# EUROPEAN PATENT APPLICATION

(11) **EP 4 678 708 A1**
(43) Date of publication of application: **14.01.2026**
(21) Application number: 24767052.4
(22) Date of filing: 01.03.2024
(51) Int. Cl.: C09J 183/04, C09J 7/35, H01L 21/304

(54) **ADHESIVE COMPOSITION, LAMINATE, AND METHOD FOR PRODUCING PROCESSED SEMICONDUCTOR SUBSTRATE**

(30) Priority: 08.03.2023 JP 2023035484
(71) Applicant: Nissan Chemical Corporation, Tokyo 103-6119 (JP)
(72) Inventor: FUKUDA, Takuya, Toyama-shi, Toyama 939-2792 (JP); YAGYU, Masafumi, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2024/007757
(87) International publication number: WO 2024/185684

(57) **Abstract**

Provided is an adhesive composition cured by a hydrosilylation reaction, in which an adhesive layer formed from the adhesive composition has an elongation of 70% or more.

## Description

### Technical Field

The present invention relates to an adhesive composition, a laminate, and a method for manufacturing a processed semiconductor substrate.

### Background Art

For a semiconductor wafer that has been conventionally integrated in a two-dimensional planar direction, a semiconductor integration technology is required by which a planar surface is further integrated (laminated) also in a three-dimensional direction for the purpose of further integration. This three-dimensional lamination is a technology of integrating multiple layers while connecting the layers by a through-silicon via (TSV). At the time of multilayer integration, respective wafers to be integrated are thinned by polishing on the side opposite to the formed circuit surface (that is, the back surface), and the thinned semiconductor wafers are laminated.

A semiconductor wafer before thinning (also referred to herein simply as a wafer) is adhered to a support in order to be polished with a polishing apparatus. The adhesion at that time needs to be easily released after polishing, and therefore is referred to as temporary adhesion. This temporary adhesion must allow for easy removal from the support. Otherwise, the thinned semiconductor wafer may be cut or deformed when a large force is applied for the removal. The removal is easily performed such that such a situation does not occur. On the other hand, at the time of polishing the back surface of the semiconductor wafer, it is not preferable that the semiconductor wafer be detached or displaced due to polishing stress. Therefore, the performance required for temporary adhesion is to withstand the stress during polishing and to allow for easy removal after polishing.

As a temporary adhesive used for such temporary adhesion, adhesives containing polydimethylsiloxane (Patent Literature 1 and 2) and the like have been proposed.

### Citation List

### Patent Literature

Patent Literature 1: WO 2017/221772 A
Patent Literature 2: WO 2022/202153 A

### Summary of Invention

### Technical Problem

As semiconductor integration technologies diversify, a semiconductor wafer or the like in contact with an adhesive layer formed from a temporary adhesive may be exposed to a high temperature.

The present invention has been made in view of the above circumstances, and an object thereof is to provide an adhesive composition capable of forming an adhesive layer having good adhesiveness even under a high-temperature environment, a laminate using the adhesive composition, and a method for manufacturing a processed semiconductor substrate or electronic device layer using the laminate.

### Solution to Problem

As a result of intensive studies to solve the above problem, the present inventors have found that the above problem can be solved, and completed the present invention having the following gist.

In other words, the present invention includes the following aspects.
[1] An adhesive composition cured by a hydrosilylation reaction, wherein
   an adhesive layer formed from the adhesive composition has an elongation of 70% or more.
[2] The adhesive composition according to [1], wherein the adhesive layer has a stress of 0.40 MPa or less at 20% elongation.
[3] The adhesive composition according to [1] or [2], wherein the adhesive layer has an elongation of 150% or less.
[4] The adhesive composition according to [2] or [3], wherein the adhesive layer has a stress of 0.05 MPa or more at 20% elongation.
[5] The adhesive composition according to any one of [1] to [4], including: a component (A-1) having an alkenyl group having 2 to 40 carbon atoms and being bonded to a silicon atom; and a component (A-2) having an Si-H group.
[6] The adhesive composition according to [5], wherein the component (A-1) contains a polyorganosiloxane (a1) having an alkenyl group having 2 to 40 carbon atoms and being bonded to a silicon atom.
[7] The adhesive composition according to [5] or [6], wherein the component (A-2) contains a polyorganosiloxane having an Si-H group.
[8] The adhesive composition according to any one of [1] to [7], including: a polyorganosiloxane as a component that does not cause a hydrosilylation reaction.
[9] The adhesive composition according to any one of [1] to [8], used to form an adhesive layer of a laminate including
   a semiconductor substrate or an electronic device layer,
   a support substrate, and
   the adhesive layer provided between the semiconductor substrate or the electronic device layer and the support substrate.
[10] A laminate including:
   a semiconductor substrate or an electronic device layer;
   a support substrate; and
   an adhesive layer provided between the semiconductor substrate or the electronic device layer and the support substrate, wherein
   the adhesive layer is an adhesive layer formed from the adhesive composition according to any one of [1] to [9].
[11] The laminate according to [10], further including: a release agent layer provided between the semiconductor substrate or the electronic device layer and the support substrate.
[12] A method for manufacturing a processed semiconductor substrate or electronic device layer, the method including:
   Step 5A of processing the semiconductor substrate of the laminate according to [10], or Step 5B of processing the electronic device layer of the laminate according to [10]; and
   Step 6A of separating the semiconductor substrate processed in Step 5A and the support substrate from each other, or Step 6B of separating the electronic device layer processed in Step 5B and the support substrate from each other.

### Advantageous Effects of Invention

According to the present invention, it is possible to provide an adhesive composition capable of forming an adhesive layer having good adhesiveness even under a high-temperature environment, a laminate using the adhesive composition, and a method for manufacturing a processed semiconductor substrate or electronic device layer using the laminate.

### Brief Description of Drawings

[Fig. 1] Fig. 1 is a schematic cross-sectional view of an example of a laminate according to a first embodiment.
[Fig. 2] Fig. 2 is a schematic cross-sectional view of another example of the laminate according to the first embodiment.
[Fig. 3A] Fig. 3A is a schematic cross-sectional view for illustrating a method for producing a laminate showing an example according to the first embodiment (part 1).
[Fig. 3B] Fig. 3B is a schematic cross-sectional view for illustrating the method for producing a laminate showing an example according to the first embodiment (part 2).
[Fig. 4] Fig. 4 is a schematic cross-sectional view of an example of a laminate according to a second embodiment.
[Fig. 5] Fig. 5 is a schematic cross-sectional view of another example of the laminate according to the second embodiment.
[Fig. 6A] Fig. 6A is a schematic cross-sectional view for illustrating a method for producing a laminate showing an example according to the second embodiment (part 1).
[Fig. 6B] Fig. 6B is a schematic cross-sectional view for illustrating the method for producing a laminate showing an example according to the second embodiment (part 2).
[Fig. 6C] Fig. 6C is a schematic cross-sectional view for illustrating the method for producing a laminate showing an example according to the second embodiment (part 3).
[Fig. 7A] Fig. 7A is a schematic cross-sectional view for illustrating a method for processing a laminate showing an example according to the first embodiment (part 1).
[Fig. 7B] Fig. 7B is a schematic cross-sectional view for illustrating the method for processing a laminate showing an example according to the first embodiment (part 2).
[Fig. 7C] Fig. 7C is a schematic cross-sectional view for illustrating the method for processing a laminate showing an example according to the first embodiment (part 3).
[Fig. 7D] Fig. 7D is a schematic cross-sectional view for illustrating the method for processing a laminate showing an example according to the first embodiment (part 4).
[Fig. 8A] Fig. 8A is a schematic cross-sectional view for illustrating a method for processing a laminate showing an example according to the second embodiment (part 1).
[Fig. 8B] Fig. 8B is a schematic cross-sectional view for illustrating the method for processing a laminate showing an example according to the second embodiment (part 2).
[Fig. 8C] Fig. 8C is a schematic cross-sectional view for illustrating the method for processing a laminate showing an example according to the second embodiment (part 3).
[Fig. 8D] Fig. 8D is a schematic cross-sectional view for illustrating the method for processing a laminate showing an example according to the second embodiment (part 4).
[Fig. 8E] Fig. 8E is a schematic cross-sectional view for illustrating the method for processing a laminate showing an example according to the second embodiment (part 5).
[Fig. 8F] Fig. 8F is a schematic cross-sectional view for illustrating the method for processing a laminate showing an example according to the second embodiment (part 6).

### Description of Embodiments

### (Adhesive composition)

An adhesive composition of the present invention is an adhesive composition cured by a hydrosilylation reaction.

An adhesive layer formed from the adhesive composition has an elongation of 70% or more.

The present inventors have conducted intensive studies in order to provide an adhesive composition capable of forming an adhesive layer having good adhesiveness even under a high-temperature environment.

The present inventors conducted studies and obtained the following findings.

When an adherend (such as a semiconductor substrate and an electronic device layer) in contact with an adhesive layer is exposed to a high temperature (for example, 300°C to 350°C) for a long period of time (for example, 8 hours) before or during processing, the adhesiveness of the adhesive layer decreases. The decrease in adhesiveness is caused, for example, by generation of voids or the like between the adhesive layer and the adherend.

The present inventors consider that the decrease in adhesiveness is caused by inability of the adhesive layer to follow the prolonged thermal expansion of the adherend when exposed to a high temperature.

Therefore, the present inventors have found that the use of an adhesive layer having a greater elongation than that of an adhesive layer formed from a conventional adhesive composition cured by a hydrosilylation reaction results in good adhesiveness even under a high-temperature environment, thereby leading to the present invention.

The adhesive layer has an elongation of 70% or more, more preferably 80% or more, and particularly preferably 90% or more.

The upper limit of the elongation of the adhesive layer is not particularly limited, but the elongation of the adhesive layer is preferably 200% or less, more preferably 170% or less, and particularly preferably 150% or less.

The stress of the adhesive layer at 20% elongation is not particularly limited, but is preferably 0.40 MPa or less. When the stress of the adhesive layer at 20% elongation is 0.40 MPa or less, since the adhesive layer is relatively soft, adhesiveness under a high-temperature environment can be further improved.

The lower limit value of the stress of the adhesive layer at 20% elongation is not particularly limited, but the stress of the adhesive layer at 20% elongation is preferably 0.05 MPa or more.

The elastic modulus (storage elastic modulus) of the adhesive layer is not particularly limited, but is preferably 0.1 MPa or more and more preferably 0.2 MPa or more from the viewpoint of stability at the time of adhesion.

The upper limit value of the elastic modulus of the adhesive layer is not particularly limited, but the elastic modulus of the adhesive layer is preferably 50 MPa or less and more preferably 20 MPa or less from the viewpoint of film flexibility.

The tensile strength of the adhesive layer is not particularly limited, but is preferably 0.1 MPa or more and more preferably 0.3 MPa or more from the viewpoint of stability at the time of adhesion.

The upper limit value of the tensile strength of the adhesive layer is not particularly limited, but the tensile strength of the adhesive layer is preferably 20 MPa or less and more preferably 10 MPa or less from the viewpoint of film flexibility.

Here, the mechanical properties (elongation, stress at 20% elongation, elastic modulus, and tensile strength) of the adhesive layer can be determined as follows.

### <<Preparation of adhesive layer for mechanical properties test>>

A 100 mm silicon wafer (thickness: 700 µm) is evenly covered with aluminum foil, and an adhesive composition is applied thereon by spin coating, and heated on a hot plate set at 110°C for 1.5 minutes followed by heating on a hot plate set at 200°C for 9 minutes, thereby forming an adhesive layer having a thickness of about 100 µm. Thereafter, the aluminum foil with the adhesive layer is removed from the silicon wafer.

Thereafter, the aluminum foil with the adhesive layer is immersed in 6 N hydrochloric acid to dissolve the aluminum foil, and the remaining film of the adhesive layer is recovered. The recovered film is cut into a width of 5 mm and a length of 10 cm.

### <<Test device>

· Dynamic viscoelasticity (DMA) device: Q-800 manufactured by TA Instruments Japan Inc.

### <<Measurement test>>

The cut film of the adhesive layer is attached and fixed to a jig of the DMA device, and gradually pulled in the major axis direction. When distortion (deformation that occurs when the film is pulled in the major axis direction) is generated in the film, the temperature is fixed at 30°C, and the tensile speed is 3.0 N/min.

The elongation at the time when the film breaks is defined as the elongation (%). An elongation of 100% indicates that the film broke when it was stretched twice the length.

The stress when the film is stretched by 20% is defined as the stress at 20% elongation (MPa).

The storage elastic modulus calculated from the stress applied when a strain of 0.5% to 1.0% is applied to the film is defined as an elastic modulus.

The maximum stress applied until the film breaks is defined as the tensile strength.

A method for controlling the elongation, stress at 20% elongation, elastic modulus, and tensile strength of the adhesive layer is not particularly limited. Here, a material used in examples described below will be described as an example. By reducing the addition amount of vinyl group-containing MQ resin (manufactured by Wacker Chemie AG), the elastic modulus and the stress at 20% elongation can be reduced, and the elongation can be further increased. This is thought to be because the vinyl group-containing MQ resin as a solid affects the hardness in the film. In addition, when the addition amount of a material that is not involved in the hydrosilylation reaction, such as the polyorganosiloxane represented by Formula (M1) (manufactured by Wacker Chemie AG, trade name: GENIOPLAST GUM), is large, it affects the film by making it more brittle, so that the elongation decreases. Furthermore, by increasing the addition amount of vinyl group-containing linear polydimethylsiloxane v3 having a viscosity of 1,000 mPa ·s and represented by Formula (W) (manufactured by Wacker Chemie AG), or SiH group-containing linear polydimethylsiloxane (manufactured by Wacker Chemie AG), the number of reaction sites for hydrosilylation increases, which can improve the film strength and thereby increase the tensile strength.

The adhesive composition cured by a hydrosilylation reaction specifically disclosed in WO 2017/221772 A and WO 2022/202153 A by the present applicant contains large amounts of vinyl group-containing MQ resin and polyorganosiloxane not involved in hydrosilylation, and therefore, the film is hard and brittle. For this reason, the adhesive layer formed from the adhesive composition has an elongation less than 70%.

The adhesive composition is preferably used to form an adhesive layer of a laminate including a semiconductor substrate or an electronic device layer, a support substrate, and the adhesive layer provided between the semiconductor substrate or the electronic device layer and the support substrate.

Examples of the adhesive composition include, but are not limited to, a polysiloxane-based adhesive, an acrylic resin-based adhesive, an epoxy resin-based adhesive, a polyamide-based adhesive, a polystyrene-based adhesive, a polyimide adhesive, and a phenolic resin-based adhesive.

Among them, a polysiloxane-based adhesive is preferable as the adhesive composition because the adhesive composition exhibits a suitable adhesive function during processing of the semiconductor substrate or the like, can be suitably released after processing, has superior heat resistance, and can be suitably removed by a cleaning agent composition.

### <Adhesive component>

The adhesive composition contains a component cured by a hydrosilylation reaction.

The component cured by a hydrosilylation reaction is an adhesive component.

The component cured by a hydrosilylation reaction is not particularly limited, but preferably contains a component having an alkenyl group having 2 to 40 carbon atoms and being bonded to a silicon atom (hereinafter, sometimes referred to as "component (A-1)"), a component having an Si-H group (hereinafter sometimes referred to as "component (A-2)"), a platinum group metal-based catalyst (A-3), and a crosslinking inhibitor (A-4).

### <<Component (A-1) and component (A-2)>>

The adhesive composition preferably contains the component (A-1).

The adhesive composition preferably contains the component (A-2).

Hereinafter, the combination of the component (A-1), the component (A-2), the platinum group metal-based catalyst (A-3), and the crosslinking inhibitor (A-4) are sometimes referred to as "component (A) to be cured" or "component (A)."

From the viewpoint of suitably obtaining the effect of the present invention, the component (A-1) preferably contains a polyorganosiloxane (a1) having an alkenyl group having 2 to 40 carbon atoms and being bonded to a silicon atom.

From the viewpoint of suitably obtaining the effect of the present invention, the component (A-2) preferably contains a polyorganosiloxane (a2) having an Si-H group.

Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

In another preferred aspect, the adhesive composition cured by a hydrosilylation reaction includes a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A-3). The polysiloxane (A1) includes: a polyorganosiloxane (a1') containing one or two or more units selected from the group consisting of a siloxane unit (Q' unit) represented by SiO₂, a siloxane unit (M' unit) represented by R¹' R²' R³' SiO_{1/2}, a siloxane unit (D' unit) represented by R⁴'R⁵'SiO_{2/2}, and a siloxane unit (T' unit) represented by R⁶'SiO_{3/2}, and also containing at least one selected from the group consisting of M' units, D' units, and T' units; and a polyorganosiloxane (a2') containing one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and also containing at least one selected from the group consisting of M" units, D" units, and T" units.

(a1') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom, and each independently represent an optionally substituted alkyl group or an optionally substituted alkenyl group, provided that at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom, and each independently represent an optionally substituted alkyl group or a hydrogen atom, provided that at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, but is preferably a linear or branched alkyl group, and the number of carbon atoms thereof is not particularly limited, but is usually 1 to 40, preferably 30 or less, more preferably 20 or less, and still more preferably 10 or less.

Specific examples of the optionally substituted linear or branched alkyl group include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6. Among them, a methyl group is particularly preferable.

Specific examples of the optionally substituted cyclic alkyl group include, but are not limited to, a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 to 6.

The alkenyl group may be linear or branched, and the number of carbon atoms thereof is not particularly limited, but is usually 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, and more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl, and the number of carbon atoms thereof is usually 4 to 14, preferably 5 to 10, and more preferably 5 to 6.

As described above, the polysiloxane (A1) contains a polyorganosiloxane (a1') and a polyorganosiloxane (a2'), and an alkenyl group contained in the polyorganosiloxane (a1') and a hydrogen atom (Si-H group) contained in the polyorganosiloxane (a2') form a crosslinked structure by a hydrosilylation reaction by the platinum group metal-based catalyst (A-3) and are cured. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more types of polyorganosiloxanes satisfying such conditions may be used in combination.

Examples of preferred combinations of two or more types selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, when two or more types of polyorganosiloxanes included in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combinations are not limited thereto.

The polyorganosiloxane (a2') contains one or two or more units selected from the group consisting of a Q" unit, an M" unit, a D" unit, and a T" unit, and contains at least one selected from the group consisting of an M" unit, a D" unit, and a T" unit. As the polyorganosiloxane (a2'), two or more types of polyorganosiloxanes satisfying such conditions may be used in combination.

Examples of preferred combinations of two or more selected from the group consisting of a Q" unit, an M" unit, a D" unit, and a T" unit include, but are not limited to, (M" unit and D" unit), (Q" unit and M" unit), and (Q" unit, T" unit, and M" unit).

The polyorganosiloxane (a1') is composed of siloxane units in which alkyl groups and/or alkenyl groups are bonded to silicon atoms of the polyorganosiloxane, and the proportion of alkenyl groups in all substituents represented by R¹' to R⁶' is preferably 0.1 to 50.0 mol%, more preferably 0.5 to 30.0 mol%, and the remaining R¹' to R⁶' can be alkyl groups.

The polyorganosiloxane (a2') is composed of siloxane units in which alkyl groups and/or hydrogen atoms are bonded to silicon atoms of the polyorganosiloxane, and the proportion of hydrogen atoms in all substituents and substitutional atoms represented by R¹" to R⁶" is preferably 0.1 to 50.0 mol%, more preferably 10.0 to 40.0 mol%, and the remaining R¹" to R⁶" can be alkyl groups.

As the polyorganosiloxane (a1) having an alkenyl group having 2 to 40 carbon atoms and being bonded to a silicon atom, for example, a polyorganosiloxane represented by the following Formula (V) and a polyorganosiloxane represented by the following Formula (W) are preferable. 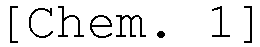 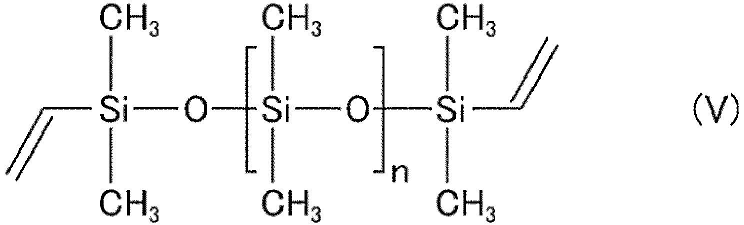
(In Formula (V), n represents the number of repeating units, and is a positive integer.) 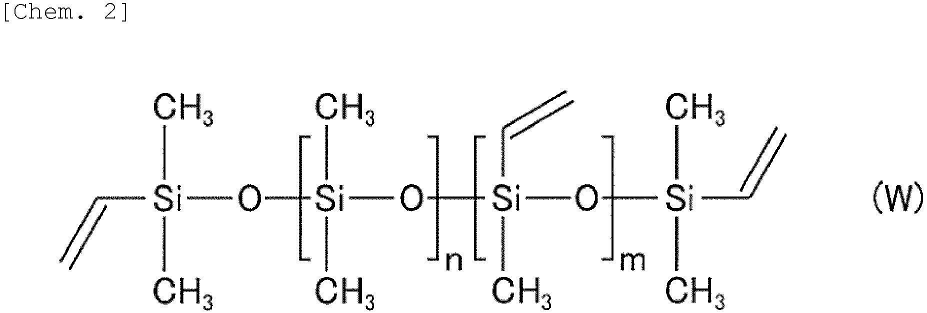
(In Formula (W), n and m represent the number of repeating units, and each independently represent a positive integer.)

When the adhesive composition contains (a1) and (a2), in a preferred aspect of the present invention, the molar ratio of the alkenyl group contained in the polyorganosiloxane (a1) and the hydrogen atom constituting the Si-H bond contained in the polyorganosiloxane (a2) is in the range of 1.0:0.5 to 1.0:0.66.

The weight average molecular weight of the polysiloxane such as the polyorganosiloxane (a1) or the polyorganosiloxane (a2) is not particularly limited, but is usually 500 to 1,000,000, and is preferably 5,000 to 50,000 from the viewpoint of achieving the effect of the present invention with good reproducibility.

In the present invention, the weight average molecular weight, the number average molecular weight, and the dispersity of the polyorganosiloxanes can be measured, for example, using a GPC apparatus (EcoSEC, HLC-8320GPC manufactured by Tosoh Corporation) and a GPC column (TSKgel SuperMultipore HZ-N and TSKgel SuperMultipore HZ-H manufactured by Tosoh Corporation), at a column temperature of 40°C, using tetrahydrofuran as an eluent (elution solvent), at a flow rate of 0.35 mL/min, and using polystyrene (Shodex from Showa Denko K.K.) as a standard sample.

The viscosities of the polyorganosiloxane (a1) and the polyorganosiloxane (a2) are not particularly limited, but are each usually 10 to 1,000,000 (mPa·s), and preferably 50 to 10,000 (mPa·s) from the viewpoint of achieving the effect of the present invention with good reproducibility. The viscosities of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction. Accordingly, the mechanism of curing is different from a mechanism, for example, through silanol groups, and therefore, any siloxane does not need to contain a silanol group or a functional group that forms a silanol group by hydrolysis, such as an alkyloxy group.

### <<Platinum group metal-based catalyst (A-3)>>

The platinum group metal-based catalyst is a platinum-based metal catalyst.

Such a platinum-based metal catalyst is a catalyst for promoting a hydrosilylation reaction between an alkenyl group and an Si-H group.

As a specific example of the platinum-based metal catalyst, a known platinum-based compound (platinum or a compound containing platinum) can be used.

Specific examples thereof include platinum fine powder, platinum black, chloroplatinic acid, alcohol-modified chloroplatinic acid, a complex of chloroplatinic acid and a diolefin, platinum-olefin complexes, platinum-carbonyl complexes (such as platinum bis(acetoacetate) and platinum bis(acetylacetonate)), chloroplatinic acid-alkenylsiloxane complexes (such as chloroplatinic acid-divinyltetramethyldisiloxane complexes and chloroplatinic acid-tetravinyltetramethylcyclotetrasiloxane complexes), platinum-alkenylsiloxane complexes (such as platinum-divinyltetramethyldisiloxane complexes and platinum-tetravinyltetramethylcyclotetrasiloxane complexes), and complexes of chloroplatinic acid and acetylene alcohols. Among them, platinum-alkenylsiloxane complexes are particularly preferable because these have a high effect of promoting a hydrosilylation reaction.

These catalysts for a hydrosilylation reaction may be used alone or in combination of two or more thereof.

The alkenylsiloxanes used in the platinum-alkenylsiloxane complexes are not particularly limited, but examples thereof include 1,3-divinyl-1,1,3,3-tetramethyldisiloxane; 1,3,5,7-tetramethyl-1,3,5,7-tetravinylcyclotetrasiloxane; alkenylsiloxane oligomers in which some of the methyl groups of these alkenylsiloxanes are substituted with ethyl groups, phenyl groups, or the like; and alkenylsiloxane oligomers in which the vinyl groups of these alkenylsiloxanes are substituted with allyl groups, hexenyl groups, or the like. In particular, 1,3-divinyl-1,1,3,3-tetramethyldisiloxane is preferable because the platinum-alkenylsiloxane complexes to be produced have good stability.

The content of the platinum group metal-based catalyst (A-3) in the adhesive composition is not particularly limited, but is, for example, in the range of 0.1 to 50.0 ppm based on the total mass of the component (A-1) and the component (A-2).

### <<Crosslinking inhibitor (A-4)>>

The crosslinking inhibitor (A-4) (also referred to as a polymerization inhibitor) is not particularly limited as long as it can suppress the progress of the hydrosilylation reaction, and specific examples thereof include, but are not limited to, alkynylalkyl alcohols which may be substituted with an aryl group, such as 1-ethynyl-1-cyclohexanol and 1,1-diphenyl-2-propyne-1-ol.

The content of the crosslinking inhibitor (A-4), based on the total mass of the component (A-1) and the component (A-2), is usually 1,000.0 ppm or more from the viewpoint of obtaining the effect thereof, and 10,000.0 ppm or less from the viewpoint of preventing excessive suppression of the hydrosilylation reaction.

### <Release agent component>

The adhesive composition may contain a component that does not cause a hydrosilylation reaction as a release agent component (hereinafter sometimes referred to as a component (B)). Here, examples of the component (B) include a polyorganosiloxane. By including such a component (B) in the adhesive composition, the obtained adhesive layer can be suitably released with good reproducibility.

Typical examples of such a component (B) include a polyorganosiloxane, and specific examples thereof include, but are not limited to, an epoxy group-containing polyorganosiloxane, a methyl group-containing polyorganosiloxane, and a phenyl group-containing polyorganosiloxane.

In addition, examples of the component (B) include polydimethylsiloxane. The polydimethylsiloxane may be modified. Examples of the optionally modified polydimethylsiloxane include, but are not limited to, an epoxy group-containing polydimethylsiloxane, an unmodified polydimethylsiloxane, and a phenyl group-containing polydimethylsiloxane.

Preferred examples of the polyorganosiloxane as the component (B) include, but are not limited to, an epoxy group-containing polyorganosiloxane, a methyl group-containing polyorganosiloxane, and a phenyl group-containing polyorganosiloxane.

The weight average molecular weight of the polyorganosiloxane as the component (B) is not particularly limited, but is usually 100,000 to 2,000,000, and is preferably 200,000 to 1,200,000 and more preferably 300,000 to 900,000 from the viewpoint of achieving the effect of the present invention with good reproducibility. In addition, the dispersity is not particularly limited, but is usually 1.0 to 10.0, and is preferably 1.5 to 5.0 and more preferably 2.0 to 3.0 from the viewpoint of achieving suitable release with good reproducibility, and the like. The weight average molecular weight and the dispersity can be measured by the above-described method relating to the polyorganosiloxane.

The viscosity of the polyorganosiloxane as the component (B) is not particularly limited, but is usually 1,000 to 2,000,000 mm²/s. The value of the viscosity of the polyorganosiloxane as the component (B) is expressed by kinematic viscosity, and centistokes (cSt) = mm²/s. The value can also be determined by dividing the viscosity (mPa·s) by the density (g/cm³). In other words, the value can be determined from the viscosity and density measured with an E-type rotational viscometer at 25°C, and can be calculated from the equation: kinematic viscosity (mm²/s) = viscosity (mPa·s)/density (g/cm³).

Examples of the epoxy group-containing polyorganosiloxane include those containing a siloxane unit (D¹⁰ unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group may include the above-described examples.

The epoxy group in the organic group containing an epoxy group may be an independent epoxy group without being fused with another ring, or may be an epoxy group forming a fused ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferred examples of the epoxy group-containing polyorganosiloxane may include, but are not limited to, an epoxy group-containing polydimethylsiloxane.

The epoxy group-containing polyorganosiloxane contains the above-described siloxane unit (D¹⁰ unit), but may contain, in addition to the D¹⁰ unit, Q units, M units, and/or T units.

In a preferred aspect of the present invention, specific examples of the epoxy group-containing polyorganosiloxane include a polyorganosiloxane composed only of D¹⁰ units, a polyorganosiloxane containing D¹⁰ units and Q units, a polyorganosiloxane containing D¹⁰ units and M units, a polyorganosiloxane containing D¹⁰ units and T units, a polyorganosiloxane containing D¹⁰ units, Q units, and M units, a polyorganosiloxane containing D¹⁰ units, M units, and T units, and a polyorganosiloxane containing D¹⁰ units, Q units, M units, and T units.

The epoxy group-containing polyorganosiloxane is preferably an epoxy group-containing polydimethylsiloxane having an epoxy value of 0.1 to 5. In addition, the weight average molecular weight is not particularly limited, but is usually 1,500 to 500,000, and is preferably 100,000 or less from the viewpoint of suppressing precipitation in the composition.

Specific examples of the epoxy group-containing polyorganosiloxane include, but are not limited to, those represented by Formulas (E1) to (E3). 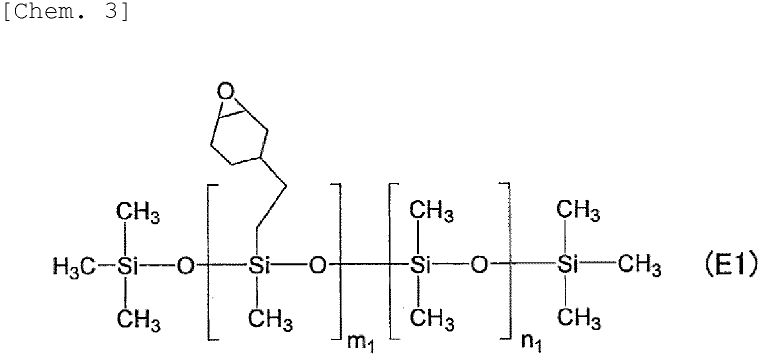 (m₁ and n₁ represent the number of respective repeating units, and are positive integers.) 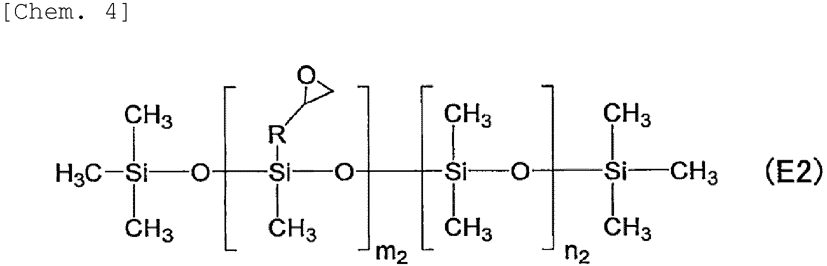 (m₂ and n₂ represent the number of respective repeating units, and are positive integers, and R is an alkylene group having 1 to 10 carbon atoms.) 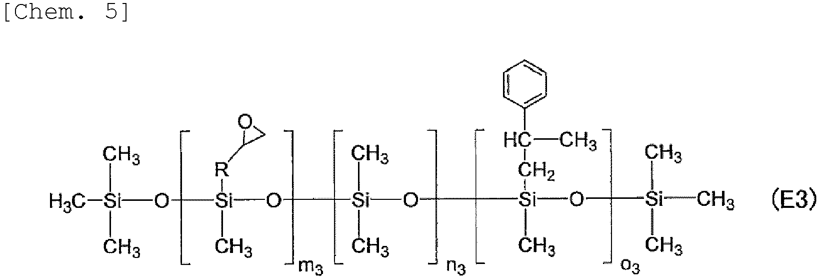 (m_{3,} n₃, and o₃ represent the number of respective repeating units, and are positive integers, and R is an alkylene group having 1 to 10 carbon atoms.)

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²¹R²¹SiO_{2/2}.

R²¹⁰ and R²²⁰ are groups bonded to a silicon atom, and each independently represent an alkyl group, with at least one of R²¹⁰ and R²²⁰ being a methyl group, and specific examples of the alkyl group may include the above-described examples.

R²¹ is a group bonded to a silicon atom and represents an alkyl group, and specific examples of the alkyl group may include the above-described examples. Among them, a methyl group is preferable as R²¹.

In the present invention, preferred examples of the methyl group-containing polyorganosiloxane may include, but are not limited to, polydimethylsiloxane.

The methyl group-containing polyorganosiloxane contains the above-described siloxane unit (D²⁰⁰ unit or D²⁰ unit), but may contain, in addition to the D²⁰⁰ unit and the D²⁰ unit, Q units, M units, and/or T units.

In one aspect of the present invention, specific examples of the methyl group-containing polyorganosiloxane include a polyorganosiloxane composed only of D²⁰⁰ units, a polyorganosiloxane containing D²⁰⁰ units and Q units, a polyorganosiloxane containing D²⁰⁰ units and M units, a polyorganosiloxane containing D²⁰⁰ units and T units, a polyorganosiloxane containing D²⁰⁰ units, Q units, and M units, a polyorganosiloxane containing D²⁰⁰ units, M units, and T units, or a polyorganosiloxane containing D²⁰⁰ units, Q units, M units, and T units.

In a preferred aspect of the present invention, specific examples of the methyl group-containing polyorganosiloxane include a polyorganosiloxane composed only of D²⁰ units, a polyorganosiloxane containing D²⁰ units and Q units, a polyorganosiloxane containing D²⁰ units and M units, a polyorganosiloxane containing D²⁰ units and T units, a polyorganosiloxane containing D²⁰ units, Q units, and M units, a polyorganosiloxane containing D²⁰ units, M units, and T units, or a polyorganosiloxane containing D²⁰ units, Q units, M units, and T units.

Specific examples of the methyl group-containing polyorganosiloxane include, but are not limited to, those represented by Formula (M1). 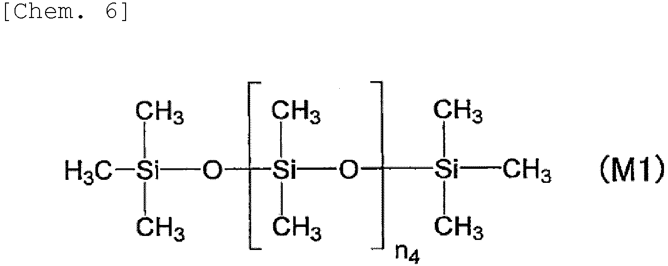 (n₄ represents the number of repeating units, and is a positive integer.)

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group may include the above-described examples, but a methyl group is preferable.

The phenyl group-containing polyorganosiloxane contains the above-described siloxane unit (D³⁰ unit), but may contain, in addition to the D³⁰ unit, Q units, M units, and/or T units.

In a preferred aspect of the present invention, specific examples of the phenyl group-containing polyorganosiloxane include a polyorganosiloxane composed only of D³⁰ units, a polyorganosiloxane containing D³⁰ units and Q units, a polyorganosiloxane containing D³⁰ units and M units, a polyorganosiloxane containing D³⁰ units and T units, a polyorganosiloxane containing D³⁰ units, Q units, and M units, a polyorganosiloxane containing D³⁰ units, M units, and T units, or a polyorganosiloxane containing D³⁰ units, Q units, M units, and T units.

Specific examples of the phenyl group-containing polyorganosiloxane include, but are not limited to, those represented by Formula (P1) or (P2). 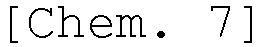 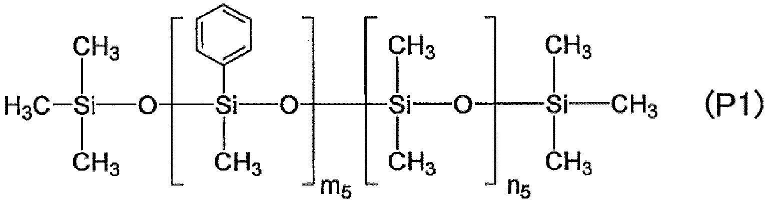 (m₅ and n₅ represent the number of respective repeating units, and are positive integers.) 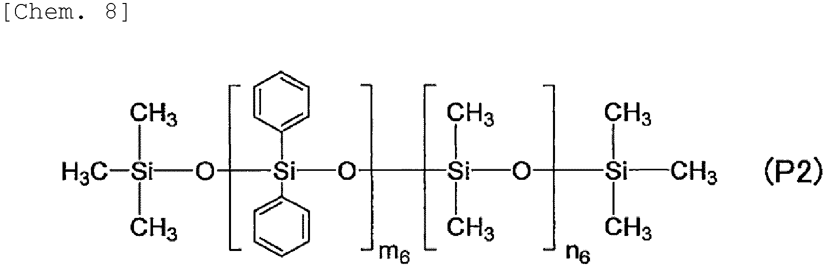 (m₆ and n₆ represent the number of respective repeating units, and are positive integers.)

The polyorganosiloxane as the release agent component (B) may be a commercially available product or a synthetic product.

Examples of commercially available products of the polyorganosiloxane include, but are not limited to, Wacker Silicone Fluid AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane (trade name: CMS-227, ECMS-327) manufactured by Gelest, Inc., epoxy group-containing polyorganosiloxane (KF-101, KF-1001, KF-1005, X-22-343) manufactured by Shin-Etsu Chemical Co., Ltd., epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc.

In one aspect, the adhesive composition used in the present invention contains a component (A) to be cured and a component (B) that does not cause a curing reaction, and in another aspect, a polyorganosiloxane is contained as the component (B).

An example of the adhesive composition used in the present invention can contain the component (A) and the component (B) in any ratio, but in consideration of the balance between adhesiveness and releasability, the ratio of the component (A) to the component (B) is preferably 99.995:0.005 to 30:70, and more preferably 99.9:0.1 to 75:25 in mass ratio [(A): (B)].

In other words, when the polyorganosiloxane component (A') cured by a hydrosilylation reaction is contained, the ratio of the component (A') to the component (B) is preferably 99.995:0.005 to 30:70, more preferably 99.9:0.1 to 75:25 in mass ratio [(A'):(B)].

The viscosity of the adhesive composition used in the present invention is not particularly limited, but is usually 500 to 20,000 mPa·s at 25°C, and preferably 1,000 to 1,0000 mPa·s at 25°C.

An example of the adhesive composition used in the present invention can be produced by mixing the component (A), and, if used, the component (B) along with a solvent.

The mixing order is not particularly limited, but examples of the method for easily producing the adhesive composition with good reproducibility include, but are not limited to, a method in which the component (A) and the component (B) are dissolved in a solvent, and a method in which parts of the component (A) and the component (B) are dissolved in a solvent, the rest is dissolved in a solvent, and the obtained solution is mixed. When the adhesive composition is prepared, the components may be appropriately heated as long as the components are not decomposed or altered.

In the present invention, for the purpose of removing foreign matter, a solvent, a solution, or the like to be used may be filtered using a filter or the like during the production of the adhesive composition or after mixing all the components.

### (Laminate)

The laminate according to the present invention includes a semiconductor substrate or an electronic device layer, a support substrate, and an adhesive layer.

The laminate according to the present invention may further include a release agent layer, and in this case, the laminate is configured to have a semiconductor substrate or an electronic device layer, a support substrate, a release agent layer, and an adhesive layer.

The adhesive layer is provided between the semiconductor substrate or the electronic device layer and the support substrate.

The laminate of the present invention is used for temporary adhesion for processing the semiconductor substrate or the electronic device layer, and can be suitably used for processing such as thinning of the semiconductor substrate or the electronic device layer.

While the semiconductor substrate is subjected to processing such as thinning, the semiconductor substrate is supported by the support substrate. Meanwhile, after the processing of the semiconductor substrate, the support substrate and the semiconductor substrate are separated from each other.

In addition, while the electronic device layer is subjected to processing such as thinning, the electronic device layer is supported by the support substrate. Meanwhile, after the processing of the electronic device layer, the support substrate and the electronic device layer are subsequently separated from each other.

After the semiconductor substrate or the electronic device layer is separated from the support substrate, residues of the release agent layer or the adhesive layer remaining on the semiconductor substrate, the electronic device layer, or the support substrate can be removed by, for example, a cleaning agent composition for cleaning the semiconductor substrate and the like.

Hereinafter, a case where the laminate has a semiconductor substrate and a case where the laminate has an electronic device layer will be described in detail separately.

The case where the laminate has a semiconductor substrate will be described in the following <First embodiment>, and the case where the laminate has an electronic device layer will be described in the following

### <Second embodiment>.

### <First embodiment>

The laminate having a semiconductor substrate is used for processing the semiconductor substrate. While the semiconductor substrate is processed, the semiconductor substrate is adhered to the support substrate. After the processing of the semiconductor substrate, the semiconductor substrate is separated from the support substrate.

### <<Semiconductor substrate>>

The main material constituting the entire semiconductor substrate is not particularly limited as long as the material is used for this type of application, and examples thereof include silicon, silicon carbide, a compound semiconductor, and a glass substrate with an organic resin.

The shape of the semiconductor substrate is not particularly limited, but is, for example, a disk shape. The disk-shaped semiconductor substrate does not need to have a completely circular surface, and for example, the outer periphery of the semiconductor substrate may have a straight portion called an orientation flat or may have a cut called a notch.

The thickness of the disk-shaped semiconductor substrate may be appropriately determined depending on the purpose of use of the semiconductor substrate and the like, and is not particularly limited, but is, for example, 500 to 1,000 µm.

The diameter of the disk-shaped semiconductor substrate may be appropriately determined depending on the purpose of use of the semiconductor substrate and the like, and is not particularly limited, but is, for example, 100 to 1,000 mm.

The semiconductor substrate may have a bump. The bump is a protruding terminal.

In the laminate, when the semiconductor substrate has a bump, the semiconductor substrate has the bump on the support substrate side.

In the semiconductor substrate, the bump is usually formed on a surface on which a circuit is formed. The circuit may be a single layer or a multilayer. The shape of the circuit is not particularly limited.

In the semiconductor substrate, a surface (back surface) opposite to the surface having the bump is a surface to be processed.

The material, size, shape, structure, and density of the bump of the semiconductor substrate are not particularly limited.

Examples of the bump include a ball bump, a print bump, a stud bump, and a plating bump.

Usually, the height, radius, and pitch of the bump are appropriately determined from the conditions of a bump height of approximately 1 to 200 um, a bump radius of 1 to 200 µm, and a bump pitch of 1 to 500 µm.

Examples of the material of the bump include low melting point solder, high melting point solder, tin, indium, gold, silver, and copper. The bump may be composed only of a single component or may be composed of a plurality of components. More specific examples thereof include alloy plating mainly composed of Sn, such as SnAg bumps, SnBi bumps, Sn bumps, and AuSn bumps.

In addition, the bump may have a laminated structure including a metal layer made of at least one of these components.

An example of the semiconductor substrate is a silicon wafer having a diameter of about 300 mm and a thickness of about 770 µm.

### <<Support substrate>>

The support substrate is not particularly limited as long as it is a member capable of supporting the semiconductor substrate when the semiconductor substrate is processed. Examples thereof include a glass support substrate and a silicon support substrate.

The shape of the support substrate is not particularly limited, but examples thereof include a disk shape. The disk-shaped support substrate does not need to have a completely circular surface shape, and for example, the outer periphery of the support substrate may have a straight portion called an orientation flat or may have a cut called a notch.

The thickness of the disk-shaped support substrate may be appropriately determined depending on the size of the semiconductor substrate and the like, and is not particularly limited, but is, for example, 500 to 1,000 µm.

The diameter of the disk-shaped support substrate may be appropriately determined depending on the size of the semiconductor substrate and the like, and is not particularly limited, but is, for example, 100 to 1,000 mm.

An example of the support substrate is a glass wafer having a diameter of about 300 mm and a thickness of about 700 µm.

When release in the laminate is performed by light irradiation, for example, a substrate having light transmissivity to light to be used is used as the support substrate.

### <<Adhesive layer>>

The adhesive layer is provided between the support substrate and the semiconductor substrate.

The adhesive layer is in contact with, for example, the semiconductor substrate. The adhesive layer may be in contact with, for example, the support substrate.

The adhesive layer is an adhesive layer formed of an adhesive composition.

The thickness of the adhesive layer included in the laminate of the present invention is not particularly limited, but is usually 5 to 500 µm, and is preferably 10 µm or more, more preferably 20 µm or more, and still more preferably 30 µm or more from the viewpoint of maintaining the film strength, and is preferably 200 µm or less, more preferably 150 µm or less, still more preferably 120 µm or less, and even more preferably 100 µm or less from the viewpoint of avoiding nonuniformity caused by a thick film.

The method for forming the adhesive layer from the adhesive composition will be described in detail in the description of <<Method for producing one example of laminate according to first embodiment>> described below.

### <<Release agent layer>>

The laminate may have a release agent layer.

In the laminate having a release agent layer, for example, the semiconductor substrate and the support substrate are separated from each other by irradiating the release agent layer with light.

The release agent layer is formed of, for example, a release agent composition.

### <<<Release agent composition>>>

The release agent composition contains, for example, at least an organic resin or a polynuclear phenol derivative, and further contains other components as necessary.

The organic resin is preferably one that can exhibit a suitable releasing ability. When the semiconductor substrate and the support substrate are separated from each other by irradiating the release agent layer with light, the organic resin absorbs light and suitably undergoes alteration that is necessary to improve releasing ability, for example, decomposition.

The laminate having the release agent layer formed of the release agent composition can be released without applying an excessive load for release, for example, by irradiating the release agent layer with a laser.

The release agent layer included in the laminate is, for example, one whose adhesive strength decreases upon laser irradiation compared to before the irradiation. In other words, in the laminate, for example, while the semiconductor substrate is subjected to processing such as thinning, the semiconductor substrate is suitably supported on the support substrate that transmits the laser via the adhesive layer and the release agent layer, and after the processing is completed, irradiation with a laser is performed from the support substrate side, so that the laser transmitted through the support substrate is absorbed by the release agent layer, and alteration (for example, separation) of the release agent layer occurs at the interface between the release agent layer and the adhesive layer, at the interface between the release agent layer and the support substrate, or inside the release agent layer. As a result, suitable release (separation) can be achieved without applying an excessive load for release.

Examples of the organic resin include a novolac resin body. Details thereof will be described below.

As a preferred embodiment, the release agent composition contains at least a novolac resin, and further contains other components such as a crosslinking agent, an acid generating agent, an acid, a surfactant, and a solvent as necessary.

As another preferred embodiment, the release agent composition contains at least a polynuclear phenol derivative and a crosslinking agent, and further contains other components such as an acid generating agent, an acid, a surfactant, and a solvent as necessary.

As still another preferred embodiment, the release agent composition contains at least an organic resin and a branched polysilane, and further contains other components such as a crosslinking agent, an acid generating agent, an acid, a surfactant, and a solvent as necessary.

### <<<<Novolac resin>>>>

The novolac resin is, for example, a resin obtained by a condensation reaction of at least one of a phenolic compound, a carbazole compound, and an aromatic amine compound with at least one of an aldehyde compound, a ketone compound, and a divinyl compound under an acid catalyst.

Examples of the phenolic compound include phenols, naphthols, anthrols, hydroxypyrenes, and the like. Examples of the phenols include phenol, cresol, xylenol, resorcinol, bisphenol A, p-tert-butylphenol, p-octylphenol, 9,9-bis(4-hydroxyphenyl)fluorene, and 1,1,2,2-tetrakis(4-hydroxyphenyl) ethane. Examples of the naphthols include 1-naphthol, 2-naphthol, 1,5-dihydroxynaphthalene, 2,7-dihydroxynaphthalene, and 9,9-bis(6-hydroxynaphthyl) fluorene. Examples of the anthrols include 9-anthrol. Examples of the hydroxypyrenes include 1-hydroxypyrene and 2-hydroxypyrene.

Examples of the carbazole compound include carbazole, 1,3,6,8-tetranitrocarbazole, 3,6-diaminocarbazole, 3,6-dibromo-9 ethylcarbazole, 3,6-dibromo-9-phenylcarbazole, 3,6-dibromocarbazole, 3,6-dichlorocarbazole, 3-amino-9-ethylcarbazole, 3-bromo-9-ethylcarbazole, 4,4'bis(9H-carbazole-9-yl)biphenyl, 4-glycidylcarbazole, 4-hydroxycarbazole, 9-(1H-benzotriazole-1-ylmethyl)-9H-carbazole, 9-acetyl-3,6-diiodocarbazole, 9-benzoylcarbazole, 9-benzoylcarbazole-6-dicarboxyaldehyde, 9-benzylcarbazole-3-carboxyaldehyde, 9-methylcarbazole, 9-phenylcarbazole, 9-vinylcarbazole, carbazole potassium, carbazole-N-carbonyl chloride, N-ethylcarbazole-3-carboxaldehyde, and N-((9-ethylcarbazole-3-yl)methylene)-2-methyl-1-indolinylamine.

Examples of the aromatic amine compound include diphenylamine and N-phenyl-1-naphthylamine.

These can be used alone or in combination of two or more thereof.

These may have a substituent. For example, these may have a substituent in the aromatic ring.

Examples of the aldehyde compound include saturated aliphatic aldehydes such as formaldehyde, paraformaldehyde, acetaldehyde, propylaldehyde, butyraldehyde, isobutyraldehyde, valeraldehyde, caproaldehyde, 2-methylbutyraldehyde, hexylaldehyde, undecanal, 7-methoxy-3,7-dimethyloctanal, cyclohexanecarbaldehyde, 3-methyl-2-butyraldehyde, glyoxal, malonaldehyde, succinaldehyde, glutaraldehyde, and adipaldehyde; unsaturated aliphatic aldehydes such as acrolein and methacrolein; heterocyclic aldehydes such as furfural and pyridinecarbaldehyde; and aromatic aldehydes such as benzaldehyde, naphthaldehyde, anthraldehyde, phenanthraldehyde, salicylaldehyde, phenylacetaldehyde, 3-phenylpropionaldehyde, tolylaldehyde, (N,N-dimethylamino)benzaldehyde, and acetoxybenzaldehyde. Among them, aromatic aldehydes are preferable.

Examples of the ketone compound include diaryl ketone compounds such as diphenyl ketone, phenyl naphthyl ketone, dinaphthyl ketone, phenyl tolyl ketone, and ditolyl ketone.

Examples of the divinyl compound include divinylbenzene, dicyclopentadiene, tetrahydroindene, 4-vinylcyclohexene, 5-vinylnorbornan-2-ene, divinylpyrene, limonene, and 5-vinylnorbornadiene.

These can be used alone or in combination of two or more thereof.

The novolac resin is, for example, a novolac resin that absorbs light emitted from the support substrate side and is altered. The alteration is, for example, photolysis.

The novolac resin contains, for example, at least one of a structural unit represented by the following Formula (C1-1), a structural unit represented by the following Formula (C1-2), and a structural unit represented by the following Formula (C1-3).

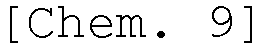

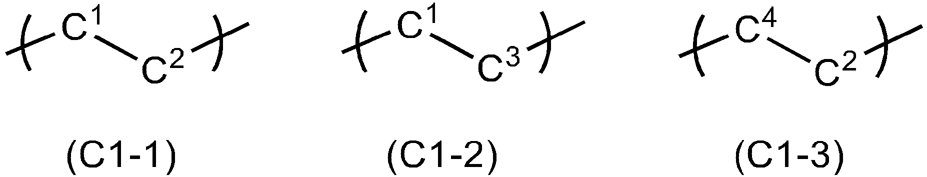

In the formula, C¹ represents a group derived from an aromatic compound containing a nitrogen atom, C² represents a group containing a tertiary carbon atom having at least one selected from the group consisting of a secondary carbon atom, a quaternary carbon atom, and an aromatic ring in a side chain, C³ represents a group derived from an aliphatic polycyclic compound, and C⁴ represents a group derived from phenol, a group derived from bisphenol, a group derived from naphthol, a group derived from biphenyl, or a group derived from biphenol.

In other words, the novolac resin contains, for example, one or two or more types of the following structural units.
· A structural unit (Formula (C1-1)) having a bond between a group derived from an aromatic compound containing a nitrogen atom and a group containing a tertiary carbon atom having at least one selected from the group consisting of a secondary carbon atom, a quaternary carbon atom, and an aromatic ring in a side chain
· A structural unit (Formula (C1-2)) having a bond between a group derived from an aromatic compound containing a nitrogen atom and a group derived from aliphatic polycyclic compound
· A structural unit ((Formula (C1-3)) having a bond between a group derived from phenol, a group derived from bisphenol, a group derived from naphthol, a group derived from biphenyl, or a group derived from biphenol, and a group containing a tertiary carbon atom having at least one selected from the group consisting of a quaternary carbon atom and an aromatic ring in a side chain

In a preferred aspect, the novolac resin contains any one or both of a structural unit (Formula (C1-1)) having a bond between a group derived from an aromatic compound containing a nitrogen atom and a group containing a tertiary carbon atom having at least one selected from the group consisting of a secondary carbon atom, a quaternary carbon atom, and an aromatic ring in a side chain, and a structural unit (Formula (C1-2)) having a bond between a group derived from an aromatic compound containing a nitrogen atom and a group derived from an aliphatic polycyclic compound.

C¹, which is the group derived from the aromatic compound containing the nitrogen atom, can be, for example, a group derived from carbazole, a group derived from N-phenyl-1-naphthylamine, a group derived from N-phenyl-2-naphthylamine, but is not limited thereto.

C², which is the group containing a tertiary carbon atom having at least one selected from the group consisting of a secondary carbon atom, a quaternary carbon atom, and an aromatic ring in a side chain, can be, for example, a group derived from 1-naphthaldehyde, a group derived from 1-pyrenecarboxaldehyde, a group derived from 4-(trifluoromethyl)benzaldehyde, a group derived from acetaldehyde, but is not limited thereto.

C³, which is the group derived from the aliphatic polycyclic compound, can be a group derived from dicyclopentadiene, but is not limited thereto.

C⁴ is a group derived from phenol, a group derived from bisphenol, a group derived from naphthol, a group derived from biphenyl, or a group derived from biphenol.

In a preferred aspect, the novolac resin contains, for example, a structural unit represented by the following Formula (C1-1-1) as the structural unit represented by Formula (C1-1).

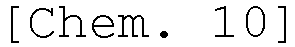

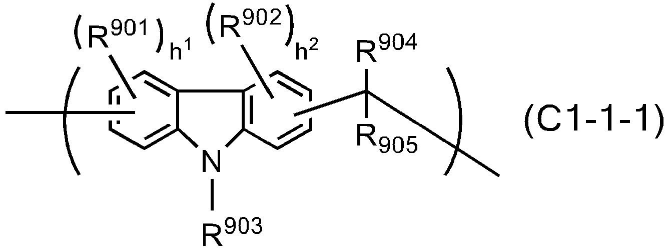

In Formula (C1-1-1), R⁹⁰¹ and R⁹⁰² represent a substituent substituted with a ring, and each independently represent a halogen atom, a nitro group, a cyano group, an amino group, a hydroxy group, a carboxy group, an optionally substituted alkyl group, an optionally substituted alkenyl group, or an optionally substituted aryl group.

R⁹⁰³ represents a hydrogen atom, an optionally substituted alkyl group, an optionally substituted alkenyl group, or an optionally substituted aryl group.

R⁹⁰⁴ represents a hydrogen atom, an optionally substituted aryl group, or an optionally substituted heteroaryl group.

R⁹⁰⁵ represents an optionally substituted alkyl group, an optionally substituted aryl group, or an optionally substituted heteroaryl group.

The group of R⁹⁰⁴ and the group of R⁹⁰⁵ may be bonded to each other to form a divalent group.

Examples of the substituent of the alkyl group and the alkenyl group include a halogen atom, a nitro group, a cyano group, an amino group, a hydroxy group, a carboxy group, an aryl group, and a heteroaryl group.

Examples of the substituent of the aryl group and the heteroaryl group include a halogen atom, a nitro group, a cyano group, an amino group, a hydroxy group, a carboxy group, an alkyl group, and an alkenyl group.

h¹ and h² each independently represent an integer of 0 to 3.

The number of carbon atoms of the optionally substituted alkyl group and the optionally substituted alkenyl group is usually 40 or less, and is preferably 30 or less and more preferably 20 or less from the viewpoint of solubility.

The number of carbon atoms of the optionally substituted aryl group and heteroaryl group is usually 40 or less, and is preferably 30 or less and more preferably 20 or less from the viewpoint of solubility.

Examples of the halogen atom include fluorine atom, chlorine atom, bromine atom, and iodine atom.

Specific examples of the optionally substituted alkyl group include, but are not limited to, a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

Specific examples of the optionally substituted alkenyl group include, but are not limited to, an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, 2-methyl-1-butenyl group, 2-methyl-2-butenyl group, 2-methyl-3-butenyl group, 3-methyl-1-butenyl group, 3-methyl-2-butenyl group, 3-methyl-3-butenyl group, 1,1-dimethyl-2-propenyl group, 1-i-propylethenyl group, 1,2-dimethyl-1-propenyl group, 1,2-dimethyl-2-propenyl group, 1-cyclopentenyl group, 2-cyclopentenyl group, 3-cyclopentenyl group, 1-hexenyl group, 2-hexenyl group, 3-hexenyl group, 4-hexenyl group, 5-hexenyl group, 1-methyl-1-pentenyl group, 1-methyl-2-pentenyl group, 1-methyl-3-pentenyl group, 1-methyl-4-pentenyl group, 1-n-butylethenyl group, 2-methyl-1-pentenyl group, 2-methyl-2-pentenyl group, 2-methyl-3-pentenyl group, 2-methyl-4-pentenyl group, 2-n-propyl-2-propenyl group, 3-methyl-1-pentenyl group, 3-methyl-2-pentenyl group, 3-methyl-3-pentenyl group, 3-methyl-4-pentenyl group, 3-ethyl-3-butenyl group, 4-methyl-1-pentenyl group, 4-methyl-2-pentenyl group, 4-methyl-3-pentenyl group, 4-methyl-4 pentenyl group, 1,1-dimethyl-2-butenyl group, 1,1-dimethyl-3-butenyl group, 1,2-dimethyl-1-butenyl group, 1,2-dimethyl-2-butenyl group, 1,2-dimethyl-3-butenyl group, 1-methyl-2-ethyl-2-propenyl group, 1-s-butylethenyl group, 1,3-dimethyl-1-butenyl group, 1,3-dimethyl-2-butenyl group, 1,3-dimethyl-3-butenyl group, 1-i-butylethenyl group, 2,2-dimethyl-3-butenyl group, 2,3-dimethyl-1-butenyl group, 2,3-dimethyl-2-butenyl group, 2,3-dimethyl-3-butenyl group, 2-i-propyl-2-propenyl group, 3,3-dimethyl-1-butenyl group, 1-ethyl-1-butenyl group, 1-ethyl-2-butenyl group, 1-ethyl-3-butenyl group, 1-n-propyl-1-propenyl group, 1-n-propyl-2-propenyl group, 2-ethyl-1-butenyl group, 2-ethyl-2-butenyl group, 2-ethyl-3-butenyl group, 1,1,2-trimethyl-2-propenyl group, 1-tertiary butylethenyl group, 1-methyl-1-ethyl-2-propenyl group, 1-ethyl-2-methyl-1-propenyl group, 1-ethyl-2-methyl-2-propenyl group, 1-i-propyl-1-propenyl group, 1-i-propyl-2-propenyl group, 1-methyl-2-cyclopentenyl group, 1-methyl-3-cyclopentenyl group, 2-methyl-1-cyclopentenyl group, 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group.

Specific examples of the optionally substituted aryl group include, but are not limited to, a phenyl group, a 2-methylphenyl group, a 3-methylphenyl group, a 4-methylphenyl group, a 2-chlorophenyl group, a 3-chlorophenyl group, a 4-chlorophenyl group, a 2-fluorophenyl group, a 3-fluorophenyl group, a 4-fluorophenyl group, a 4-methoxyphenyl group, a 4-ethoxyphenyl group, a 4-nitrophenyl group, a 4-cyanophenyl group, a 1-naphthyl group, a 2-naphthyl group, a biphenyl-4-yl group, a biphenyl-3-yl group, a biphenyl-2-yl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Specific examples of the optionally substituted heteroaryl group include, but are not limited to, a 2-thienyl group, a 3-thienyl group, a 2-furanyl group, a 3-furanyl group, a 2-oxazolyl group, a 4-oxazolyl group, a 5-oxazolyl group, a 3-isoxazolyl group, a 4-isoxazolyl group, a 5-isoxazolyl group, a 2-thiazolyl group, a 4-thiazolyl group, a 5-thiazolyl group, a 3-isothiazolyl group, a 4-isothiazolyl group, and a 5-isothiazolyl group.

Hereinafter, specific examples of the structural unit represented by Formula (C1-1-1) will be given, but the structural unit is not limited thereto.

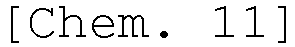

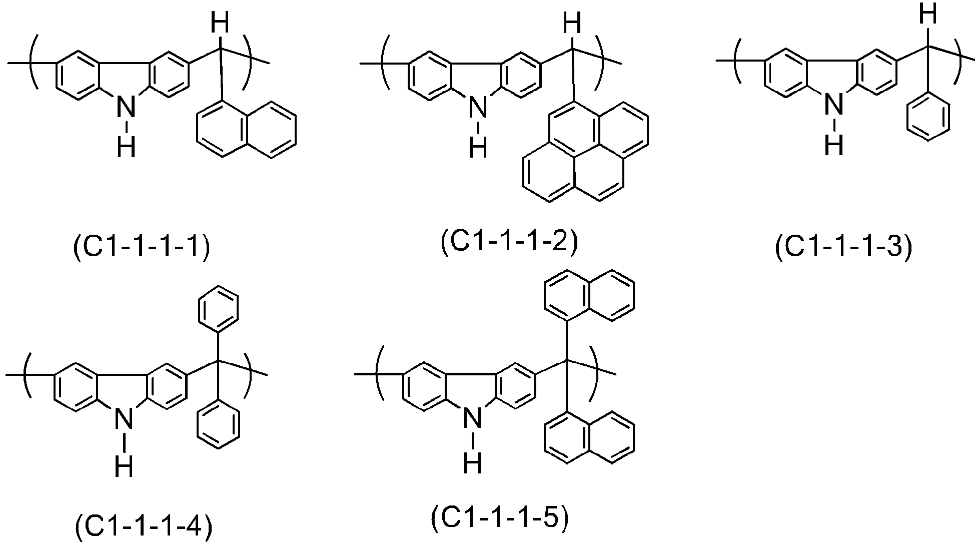

In a preferred aspect, the novolac resin contains, for example, a structural unit represented by the following Formula (C1-1-2) as the structural unit represented by Formula (C1-1).

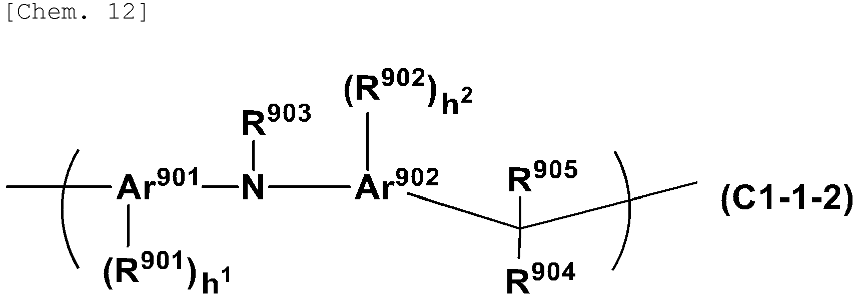

In Formula (C1-1-2), Ar⁹⁰¹ and Ar⁹⁰² each independently represent an aromatic ring such as a benzene ring or a naphthalene ring, and R⁹⁰¹ to R⁹⁰⁵, h¹, and h² have the same meanings as described above.

Hereinafter, specific examples of the structural unit represented by Formula (C1-1-2) will be given, but the structural unit is not limited thereto.

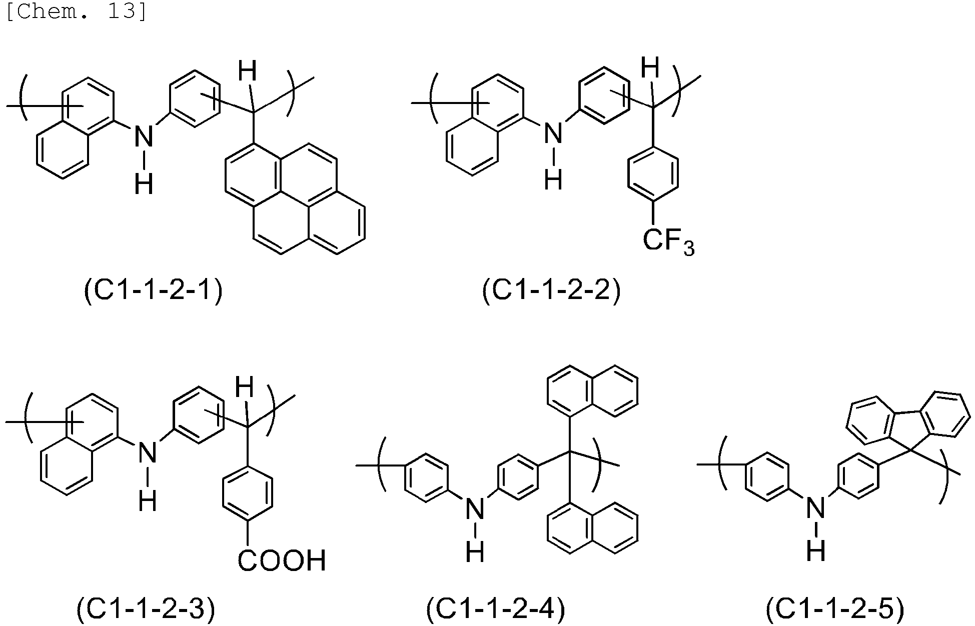

In a preferred aspect, the novolac resin contains, for example, a structural unit represented by the following Formula (C1-2-1) or (C1-2-2) as the structural unit represented by Formula (C1-2).

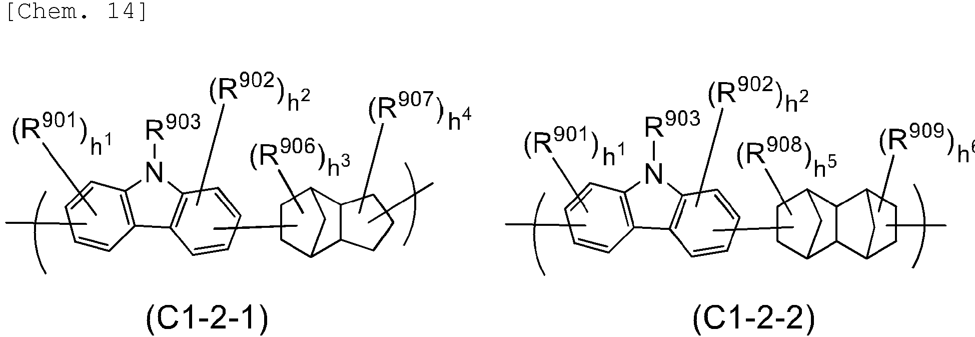

In the above formula, R⁹⁰⁶ to R⁹⁰⁹ are substituents bonded to a ring, and each independently represent a halogen atom, a nitro group, a cyano group, an amino group, a hydroxy group, a carboxy group, an optionally substituted alkyl group, an optionally substituted alkenyl group, or an optionally substituted aryl group. Specific examples and suitable numbers of carbon atoms of the halogen atom, the optionally substituted alkyl group, the optionally substituted alkenyl group, and the optionally substituted aryl group are the same as those described above, h³ to h⁶ each independently represent an integer of 0 to 3, and R⁹⁰¹ to R⁹⁰³, h¹, and h² have the same meanings as described above.

Hereinafter, specific examples of the structural units represented by Formulas (C1-2-1) and (C1-2-2) will be given, but the structural units are not limited thereto.

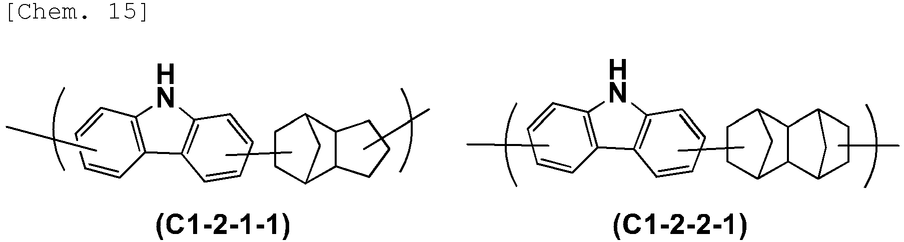

Hereinafter, specific examples of the structural unit represented by Formula (C1-3) will be given, but the structural unit is not limited thereto.

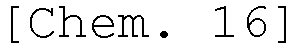

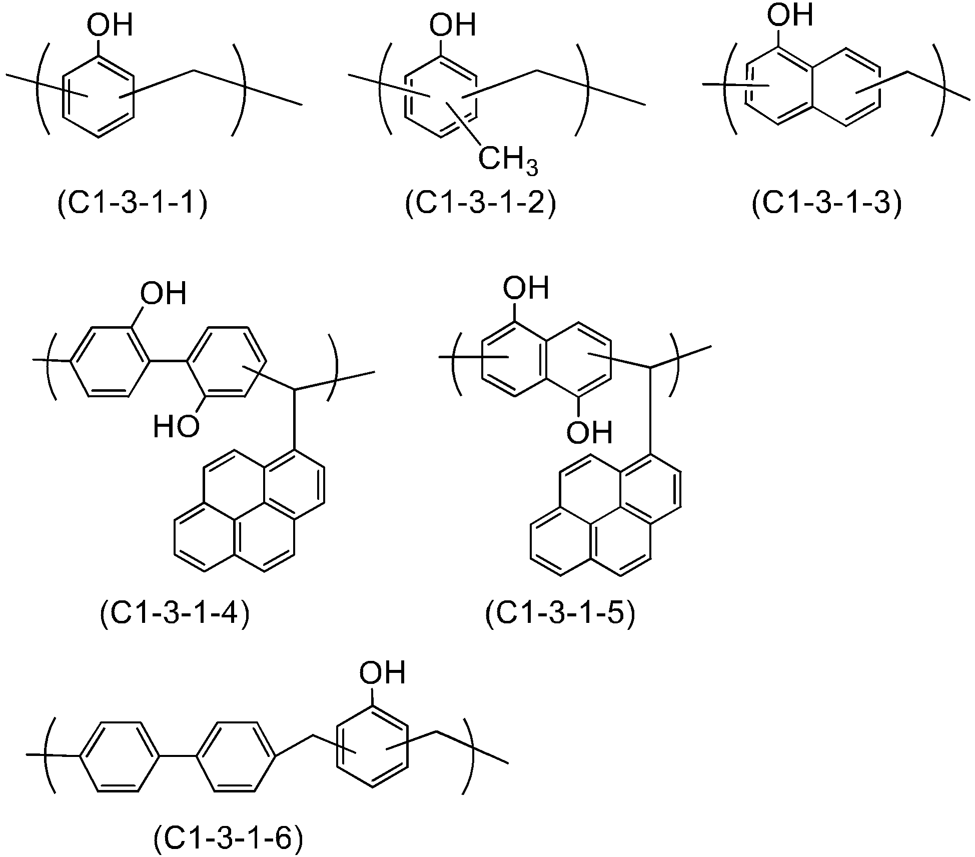

As described above, the novolac resin is, for example, a resin obtained by a condensation reaction of at least one of a phenolic compound, a carbazole compound, and an aromatic amine compound with at least one of an aldehyde compound, a ketone compound, and a divinyl compound under an acid catalyst.

In this condensation reaction, for example, an aldehyde compound or a ketone compound is usually used in a ratio of 0.1 to 10 equivalents to 1 equivalent of a benzene ring constituting a ring of a carbazole compound.

In the above condensation reaction, an acid catalyst is usually used.

Examples of the acid catalyst include, but are not limited to, mineral acids such as sulfuric acid, phosphoric acid, and perchloric acid, organic sulfonic acids such as p-toluenesulfonic acid and p-toluenesulfonic acid monohydrate, and carboxylic acids such as formic acid and oxalic acid.

The amount of the acid catalyst is appropriately determined depending on the type of the acid to be used and the like, and thus cannot be generally defined, but is usually appropriately determined from the range of 0.001 to 10,000 parts by mass with respect to 100 parts by mass of the carbazole compound.

When either the raw material compound or the acid catalyst to be used is a liquid, the condensation reaction can be performed without using a solvent in some cases, but is usually performed using a solvent.

Such a solvent is not particularly limited as long as the reaction is not inhibited, but typically includes ether compounds such as cyclic ether compounds (for example, tetrahydrofuran and dioxane).

The reaction temperature is usually appropriately determined from the range of 40°C to 200°C, and the reaction time cannot be generally specified because the reaction time varies depending on the reaction temperature, but is usually appropriately determined from the range of 30 minutes to 50 hours.

After completion of the reaction, if necessary, purification and isolation are performed according to a conventional method, and the obtained novolac resin is used for preparation of a release agent composition.

Those skilled in the art can determine the production conditions of the novolac resin without an excessive burden based on the above description and the common general technical knowledge, and therefore can produce the novolac resin.

The weight average molecular weight of the organic resin such as the novolac resin is usually 500 to 200,000, and is preferably 100,000 or less, more preferably 50,000 or less, still more preferably 10,000 or less, even more preferably 5,000 or less, and even more preferably 3,000 or less from the viewpoint of securing solubility in a solvent, favorably mixing with a branched polysilane when forming a film to obtain a uniform film, and the like, and is preferably 600 or more, more preferably 700 or more, still more preferably 800 or more, even more preferably 900 or more, and even more preferably 1,000 or more from the viewpoint of improving the film strength, and the like.

In the present invention, the weight average molecular weight, the number average molecular weight, and the dispersity of the organic resin such as the novolac resin which is a polymer can be measured, for example, using a GPC apparatus (EcoSEC, HLC-8320GPC manufactured by Tosoh Corporation) and a GPC column (TSKgel SuperMultipore HZ-N and TSKgel SuperMultipore HZ-H manufactured by Tosoh Corporation), at a column temperature of 40°C, using tetrahydrofuran as an eluent (elution solvent), at a flow rate of 0.35 mL/min, and using polystyrene (manufactured by Sigma-Aldrich Co. LLC.) as a standard sample.

The organic resin contained in the release agent composition is preferably a novolac resin, and therefore the above release agent composition preferably contains a novolac resin alone as the organic resin, but may contain other polymers together with the novolac resin for the purpose of adjusting film properties and the like.

Examples of such other polymers include a polyacrylic acid ester compound, a polymethacrylic acid ester compound, a polyacrylamide compound, a polymethacrylamide compound, a polyvinyl compound, a polystyrene compound, a polymaleimide compound, a polymaleic anhydride, and a polyacrylonitrile compound.

The content of the novolac resin in the release agent composition is not particularly limited, but is preferably 70 mass% or more based on the total amount of the polymer contained in the release agent composition.

The content of the novolac resin in the release agent composition is not particularly limited, but is preferably 50 to 100 mass% with respect to the film constituent components. In the present invention, the film constituent components mean components other than the solvent contained in the composition.

### <<<<Polynuclear phenol derivative>>>>

The polynuclear phenol derivative is represented by, for example, the following Formula (P).

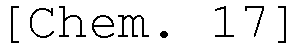

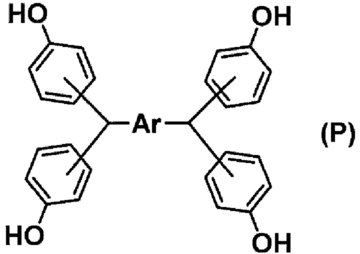

In Formula (P), Ar represents an arylene group, and the number of carbon atoms thereof is not particularly limited, but is usually 6 to 60, and is preferably 30 or less, more preferably 20 or less, still more preferably 18 or less, and even more preferably 12 or less from the viewpoint of preparing a release agent composition having excellent uniformity and obtaining a release agent layer having higher flatness with good reproducibility.

Specific examples of such an arylene group include, but are not limited to, 1,2-phenylene, 1,3-phenylene, and 1,4-phenylene; groups derived by removing two hydrogen atoms on the aromatic ring of a fused ring aromatic hydrocarbon compound such as 1,5-naphthalenediyl, 1,8-naphthalenediyl, 2,6-naphthalenediyl, 2,7-naphthalenediyl, 1,2-anthracenediyl, 1,3-anthracenediyl, 1,4-anthracenediyl, 1,5-anthracenediyl, 1,6-anthracenediyl, 1,7-anthracenediyl, 1,8-anthracenediyl, 2,3-anthracenediyl, 2,6-anthracenediyl, 2,7-anthracenediyl, 2,9-anthracenediyl, 2,10-anthracenediyl, and 9,10-anthracenediyl groups; and groups derived by removing two hydrogen atoms on the aromatic ring of a ring-linked aromatic hydrocarbon compound such as a biphenyl-4,4'-diyl group and a para-terphenyl-4,4"-diyl group.

The polynuclear phenol derivative represented by Formula (P) is preferably a polynuclear phenol derivative represented by Formula (P-1), more preferably a polynuclear phenol derivative represented by Formula (P-1-1), and still more preferably a polynuclear phenol derivative represented by Formula (P1) from the viewpoint of providing a release agent layer exhibiting good releasability and obtaining a laminate, in which a support substrate can be favorably separated, with good reproducibility.

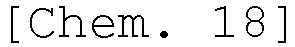

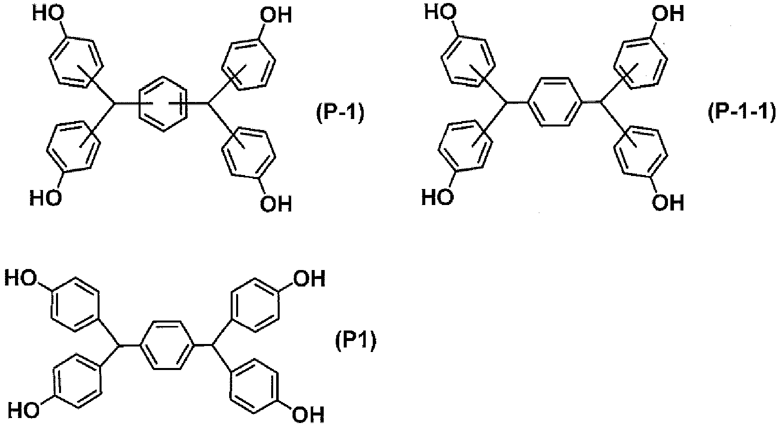

The content of the polynuclear phenol derivative in the release agent composition is not particularly limited, but is preferably 50 to 100 mass% with respect to the film constituent components.

### <<<<Branched polysilane>>>>

The above release agent composition may contain a branched polysilane.

The branched polysilane has a Si-Si bond and a branched structure. Since the branched polysilane is contained in the above release agent composition, the release agent layer formed of the obtained film cannot be suitably removed by any of an organic solvent, an acid, and a chemical solution (such as an alkaline developer or a hydrogen peroxide solution) used in manufacture of semiconductor elements, but can be suitably removed by the cleaning agent composition. As a result, residues of the release agent layer on the substrates can be suitably removed by separating the semiconductor substrate and support substrate of the laminate from each other and then cleaning each substrate with the cleaning agent composition. Although the reason for this is unclear, depending on the type of terminal group (terminal substituent (atom)) of the polysilane, the polysilane can be crosslinked by reacting with the organic resin, and the branched polysilane has more terminal groups (terminal substituents (atoms)) than a linear polysilane. Therefore, it is considered that the branched polysilane has more crosslinking points than the linear polysilane, and it is presumed that, due to moderate and appropriate curing via such an increased number of crosslinking points in the branched polysilane, both of the following properties are achieved: a property of not being suitably removed by an organic solvent, an acid, or a chemical solution (such as an alkaline developer or a hydrogen peroxide solution) used in the manufacture of semiconductor elements, and a property of being suitably removed by the cleaning agent composition.

The branched polysilane preferably contains a structural unit represented by Formula (B).

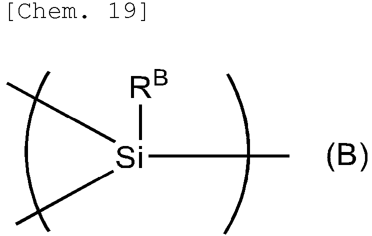

In Formula (B), R^{B} represents a hydrogen atom, a hydroxy group, a silyl group, or an organic group, and specific examples of such an organic group include hydrocarbon groups (an optionally substituted alkyl group, an optionally substituted alkenyl group, an optionally substituted aryl group, and an optionally substituted aralkyl group) and ether groups (an optionally substituted alkoxy group, an optionally substituted aryloxy group, and an optionally substituted aralkyloxy group) corresponding to those hydrocarbon groups, and in many cases, the organic group is usually a hydrocarbon group such as an alkyl group, an alkenyl group, an aryl group, or an aralkyl group. In addition, a hydrogen atom, a hydroxy group, an alkoxy group, a silyl group, or the like is often substituted at the terminal.

The optionally substituted alkyl group may be linear, branched, or cyclic.

Specific examples of the optionally substituted linear or branched alkyl group include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, and the number of carbon atoms thereof is usually 1 to 14, preferably 1 to 10, and more preferably 1 to 6.

Specific examples of the optionally substituted cyclic alkyl group include, but are not limited to, a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, and the number of carbon atoms thereof is usually 3 to 14, preferably 4 to 10, and more preferably 5 to 6.

The alkenyl group may be linear, branched, or cyclic.

Specific examples of the optionally substituted linear or branched alkenyl group include, but are not limited to, a vinyl group, an allyl group, a butenyl group, and a pentenyl group, and the number of carbon atoms thereof is usually 2 to 14, preferably 2 to 10, and more preferably 1 to 6.

Specific examples of the optionally substituted cyclic alkenyl group include, but are not limited to, cyclopentenyl and cyclohexenyl, and the number of carbon atoms thereof is usually 4 to 14, preferably 5 to 10, and more preferably 5 to 6.

Specific examples of the optionally substituted aryl group include, but are not limited to, a phenyl group, a 4-methylphenyl group, a 3-methylphenyl group, a 2-methylphenyl group, a 3,5-dimethylphenyl group, a 1-naphthyl group, and a 2-naphthyl group, and the number of carbon atoms thereof is usually 6 to 20, preferably 6 to 14, and more preferably 6 to 12.

Specific examples of the optionally substituted aralkyl group include, but are not limited to, a benzyl group, a phenethyl group, and a phenylpropyl group. The optionally substituted aralkyl group is preferably a group in which one of hydrogen atoms of an alkyl group having 1 to 4 carbon atoms is substituted with an aryl group having 6 to 20 carbon atoms.

In the optionally substituted alkoxy group, the alkoxy moiety may be linear, branched, or cyclic.

Specific examples of the optionally substituted linear or branched alkoxy group include, but are not limited to, a methoxy group, an ethoxy group, a propoxy group, an isopropoxy group, a butoxy group, a t-butoxy group, and a pentyloxy group, and the number of carbon atoms thereof is usually 1 to 14, preferably 1 to 10, and more preferably 1 to 6.

Specific examples of the optionally substituted cyclic alkoxy group include, but are not limited to, cyclopentyloxy and cyclohexyloxy, and the number of carbon atoms thereof is usually 3 to 14, preferably 4 to 10, and more preferably 5 to 6.

Specific examples of the optionally substituted aryloxy group include, but are not limited to, phenoxy, 1-naphthyloxy and 2-naphthyloxy, and the number of carbon atoms thereof is usually 6 to 20, preferably 6 to 14, and more preferably 6 to 10.

Specific examples of the optionally substituted aralkyloxy group include, but are not limited to, benzyloxy, phenethyloxy, and phenylpropyloxy. The optionally substituted aralkyloxy group is preferably a group in which one of hydrogen atoms of an alkyloxy group having 1 to 4 carbon atoms is substituted with an aryl group having 6 to 20 carbon atoms.

Specific examples of the silyl group include, but are not limited to, a silyl group, a disilanyl group, and a trisilanyl group, and the number of silicon atoms thereof is usually 1 to 10 and preferably 1 to 6.

When R^{B} is the above organic group or silyl group, at least one of the hydrogen atoms may be substituted with a substituent. Specific examples of such a substituent include a hydroxy group, an alkyl group, an aryl group, and an alkoxy group.

From the viewpoint of suppressing unintentional release when the laminate is brought into contact with any of an organic solvent, an acid, and a chemical solution (such as an alkaline developer or a hydrogen peroxide solution) used in the manufacture of semiconductor elements, suitably removing residues of the release agent layer on the substrates in a case where each substrate is cleaned with the cleaning agent composition after the semiconductor substrate and support substrate of the laminate are separated from each other, and the like, R^{B} is preferably an alkyl group or an aryl group, more preferably an aryl group, still more preferably a phenyl group, a 1-naphthyl group, or a 2-naphthyl group, and even more preferably a phenyl group.

The branched polysilane may contain a structural unit represented by the following Formula (S) or a structural unit represented by the following Formula (N) together with the structural unit represented by Formula (B). However, from the viewpoint of suppressing unintentional release when the laminate is brought into contact with any of an organic solvent, an acid, and a chemical solution (such as an alkaline developer or a hydrogen peroxide solution) used in the manufacture of semiconductor elements, from the viewpoint of suitably removing residues of the release agent layer on the substrates in a case where each substrate is cleaned with the cleaning agent composition after the semiconductor substrate and support substrate of the laminate are separated from each other, and the like, the content of the structural unit represented by Formula (B) in the branched polysilane is usually 50 mol% or more, preferably 60 mol% or more, more preferably 70 mol% or more, still more preferably 80 mol% or more, even more preferably 90 mol% or more, and even more preferably 95 mol% or more in all structural units.

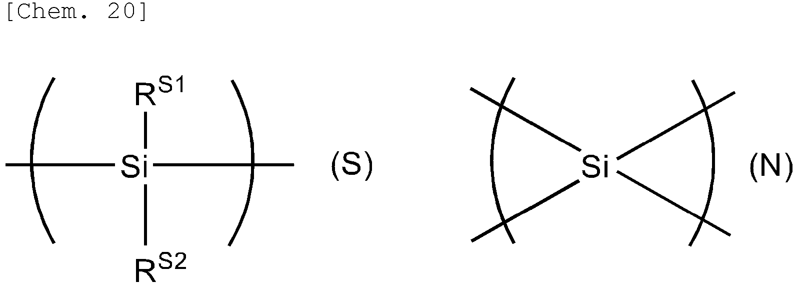

(R^{S1} and R^{S2} have the same meaning as R^{B}.)

The terminal group (terminal substituent (atom)) of the branched polysilane may be usually a hydrogen atom, a hydroxy group, a halogen atom (such as a chlorine atom), an alkyl group, an aryl group, an alkoxy group, a silyl group, or the like. Among them, a hydroxy group, a methyl group, and a phenyl group are often used, and a methyl group is particularly preferable, and the terminal group may be a trimethylsilyl group.

In one aspect, the average degree of polymerization of the branched polysilane is usually 2 to 100, preferably 3 to 80, more preferably 5 to 50, and still more preferably 10 to 30 in terms of silicon atoms (that is, the average number of silicon atoms per molecule).

In one aspect, the upper limit value of the weight average molecular weight of the branched polysilane is usually 30,000, preferably 20,000, more preferably 10,000, still more preferably 5,000, even more preferably 2,000, and even more preferably 1,500, and the lower limit value thereof is usually 50, preferably 100, more preferably 150, still more preferably 200, even more preferably 300, and even more preferably 500.

The average degree of polymerization and weight average molecular weight of the branched polysilane can be measured using a GPC apparatus (EcoSEC, HLC-8220GPC manufactured by Tosoh Corporation) and a GPC column (Shodex KF-803L, KF-802, and KF-801 manufactured by Showa Denko **K.K.,** used in this order), at a column temperature of 40°C, using tetrahydrofuran as an eluent (elution solvent), at a flow rate of 1.00 mL/min, and using polystyrene (manufactured by Sigma-Aldrich Co. LLC.) as a standard sample.

If the degree of polymerization and weight average molecular weight of the branched polysilane to be used are too low, the branched polysilane may vaporize due to heating during the formation of the release agent layer film or during processing applied to the laminate provided with the obtained release agent layer, or defects may occur due to insufficient strength of the film. On the other hand, if the degree of polymerization and molecular weight of the branched polysilane to be used are too high, depending on the type of solvent used in the preparation of the release agent composition, sufficient solubility may not be ensured, which may result in precipitation in the composition or insufficient mixing with the resin, making it difficult to obtain a highly uniform film with good reproducibility.

Therefore, it is desirable that the degree of polymerization and weight average molecular weight of the branched polysilane satisfy the above-described ranges from the viewpoint of obtaining a laminate including a release agent layer contributing to suitable manufacture of a semiconductor element with higher reproducibility.

The 5% weight reduction temperature of the branched polysilane is usually 300°C or higher, preferably 350°C or higher, more preferably 365°C or higher, still more preferably 380°C or higher, even more preferably 395°C or higher, and even more preferably 400°C or higher from the viewpoint of obtaining a release agent layer having excellent heat resistance with good reproducibility.

The 5% weight loss temperature of the branched polysilane can be measured by, for example, raising the temperature from normal temperature (25°C) to 400°C at 10°C/min under air using 2010SR manufactured by NETZSCH.

From the viewpoint of suitably removing residues of the release agent layer on the substrates in a case where each substrate is cleaned with the cleaning agent composition after the semiconductor substrate and support substrate of the laminate are separated from each other, preparing a release agent composition having excellent uniformity with good reproducibility, and the like, the branched polysilane is preferably dissolved in any one of an ether compound such as tetrahydrofuran, an aromatic compound such as toluene, a glycol ether ester compound such as propylene glycol monomethyl ether acetate, ketone compounds such as cyclohexanone and methyl ethyl ketone, and a glycol ether compound such as propylene glycol monomethyl ether. The dissolution in this case means that, when dissolution is attempted using a shaker at normal temperature (25°C) to prepare a 10 mass% solution, dissolution is visually confirmed within 1 hour.

The branched polysilane may be either a solid or a liquid at normal temperature.

The branched polysilane can be produced with reference to known methods described in, for example, JP 2011-208054 A, JP 2007-106894 A, JP 2007-145879 A, and WO2005/113648, or can also be obtained as a commercially available product. Specific examples of the commercially available product include, but are not limited to, OGSOL SI-20-10, SI-20-14, and the like, which are silicon material polysilanes manufactured by Osaka Gas Chemicals Co., Ltd.

Suitable examples of the branched polysilane include, but are not limited to, the following.

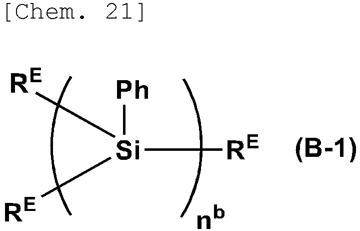

(Ph represents a phenyl group, R^{E}'s each independently represents a terminal substituent and represents an atom or a group, and n^{b} represents the number of repeating units.)

The content of the branched polysilane in the above release agent composition is usually 10 to 90 amount% with respect to the film constituent components, but is preferably 15 to 80 mass%, more preferably 20 to 70 mass%, still more preferably 25 to 60 mass%, and still more preferably 30 to 50 mass% from the viewpoint of realizing a film that can be suitably removed by a cleaning agent composition with good reproducibility although it cannot be suitably removed by an organic solvent, an acid, or a chemical solution (such as an alkaline developer or a hydrogen peroxide solution) used in the manufacture of semiconductor elements, and the like.

### <<<<Crosslinking agent>>>>

The release agent composition may include a crosslinking agent.

The crosslinking agent may cause a crosslinking reaction by self-condensation, but when crosslinkable substituents are present in the novolac resin, the crosslinking agent can cause a crosslinking reaction with these crosslinkable substituents.

Specific examples of the crosslinking agent are not particularly limited, but typically include phenol-based crosslinking agents, melamine-based crosslinking agents, urea-based crosslinking agents, and thiourea-based crosslinking agents, each of which has a crosslinkable group such as an alkoxymethyl group (for example, a hydroxymethyl group, a methoxymethyl group, or a butoxymethyl group) in the molecule, and these may be low molecular weight compounds or high molecular weight compounds.

The crosslinking agent contained in the release agent composition usually has two or more crosslinkable groups, but from the viewpoint of achieving more suitable curing with good reproducibility, the number of crosslinkable groups contained in a compound as the crosslinking agent is preferably 2 to 10, and more preferably 2 to 6.

The crosslinking agent contained in the release agent composition preferably has an aromatic ring (for example, a benzene ring or a naphthalene ring) in the molecule from the viewpoint of achieving higher heat resistance, and typical examples of such a crosslinking agent include, but are not limited to, a phenol-based crosslinking agent.

The phenol-based crosslinking agent having a crosslinkable group is a compound having a crosslinkable group bonded to an aromatic ring and having at least one of a phenolic hydroxy group and an alkoxy group derived from a phenolic hydroxy group, and examples of such an alkoxy group derived from a phenolic hydroxy group include, but are not limited to, a methoxy group and a butoxy group.

Both the aromatic ring to which the crosslinkable group is bonded and an aromatic ring to which the phenolic hydroxy group and/or the alkoxy group derived from a phenolic hydroxy group is bonded are not limited to a noncondensed ring type aromatic ring such as a benzene ring, and may be a condensed ring type aromatic ring such as a naphthalene ring or anthracene.

When a plurality of aromatic rings are present in the molecule of the phenol-based crosslinking agent, the crosslinkable group, the phenolic hydroxy group, and the alkoxy group derived from a phenolic hydroxy group may be bonded to the same aromatic ring in the molecule or may be bonded to different aromatic rings.

The aromatic ring to which the crosslinkable group, the phenolic hydroxy group, and the alkoxy group derived from a phenolic hydroxy group are bonded may be further substituted with an alkyl group such as a methyl group, an ethyl group, or a butyl group, a hydrocarbon group such as an aryl group (for example, a phenyl group), a halogen atom such as a fluorine atom, or the like.

For example, specific examples of the phenol-based crosslinking agent having a crosslinkable group include compounds represented by any of Formulas (L1) to (L4).

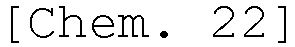

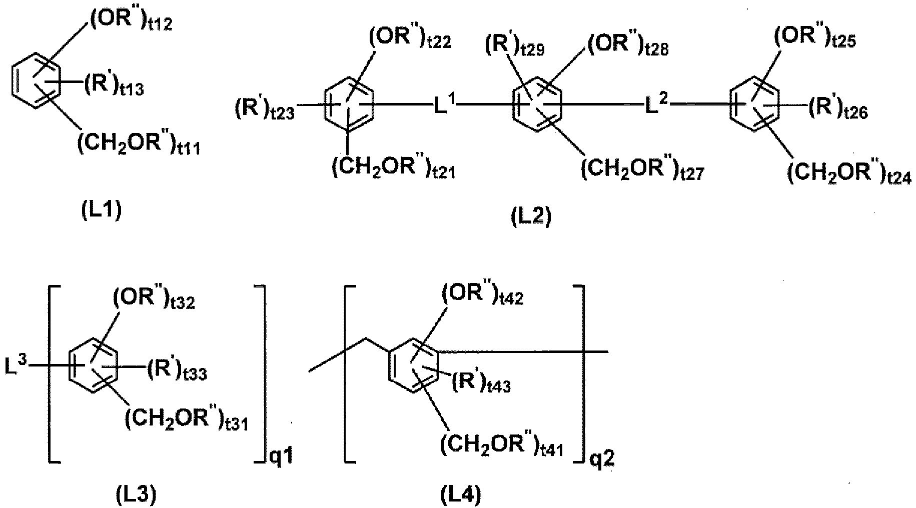

In each formula, each R' independently represents a fluorine atom, an aryl group, or an alkyl group, each R" independently represents a hydrogen atom or an alkyl group, L¹ and L² each independently represent a single bond, a methylene group, or a propane-2,2-diyl group, L³ is determined depending on q1 and represents a single bond, a methylene group, a propane-2,2-diyl group, a methanetriyl group, or an ethane-1,1,1-triyl group, t11, t12, and t13 are integers satisfying 2 ≤ t11 ≤ 5, 1 ≤ t12 ≤ 4, 0 ≤ t13 ≤ 3, and t11 + t12 + t13 ≤ 6, t21, t22, and t23 are integers satisfying 2 ≤ t21 ≤ 4, 1 ≤ t22 ≤ 3, 0 ≤ t23 ≤ 2, and t21 + t22 + t23 ≤ 5, t24, t25, and t26 are integers satisfying 2 ≤ t24 ≤ 4, 1 ≤ t25 ≤ 3, 0 ≤ t26 ≤ 2, and t24 + t25 + t26 ≤ 5, t27, t28, and t29 are integers satisfying 0 ≤ t27 ≤ 4, 0 ≤ t28 ≤ 4, 0 ≤ t29 ≤ 4, and t27 + t28 + t29 ≤ 4, t31, t32, and t33 are integers satisfying 2 ≤ t31 ≤ 4, 1 ≤ t32 ≤ 3, 0 ≤ t33 ≤ 2, and t31 + t32 + t33 ≤ 5, t41, t42, and t43 are integers satisfying 2 ≤ t41 ≤ 3, 1 ≤ t42 ≤ 2, 0 ≤ t43 ≤ 1, and t41 + t42 + t43 ≤ 4, q1 is 2 or 3, q2 represents the number of repetitions and is an integer of 0 or more, and specific examples of the aryl group and the alkyl group include the same as the following specific examples, but the aryl group is preferably a phenyl group, and the alkyl group is preferably a methyl group or a t-butyl group.

Hereinafter, specific examples of the compounds represented by Formulas (L1) to (L4) will be given, but the compounds are not limited thereto. These compounds may be synthesized by a known method, and can also be obtained, for example, as a product of Asahi Yukizai Corporation or Honshu Chemical Industry Co., Ltd.

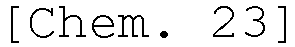

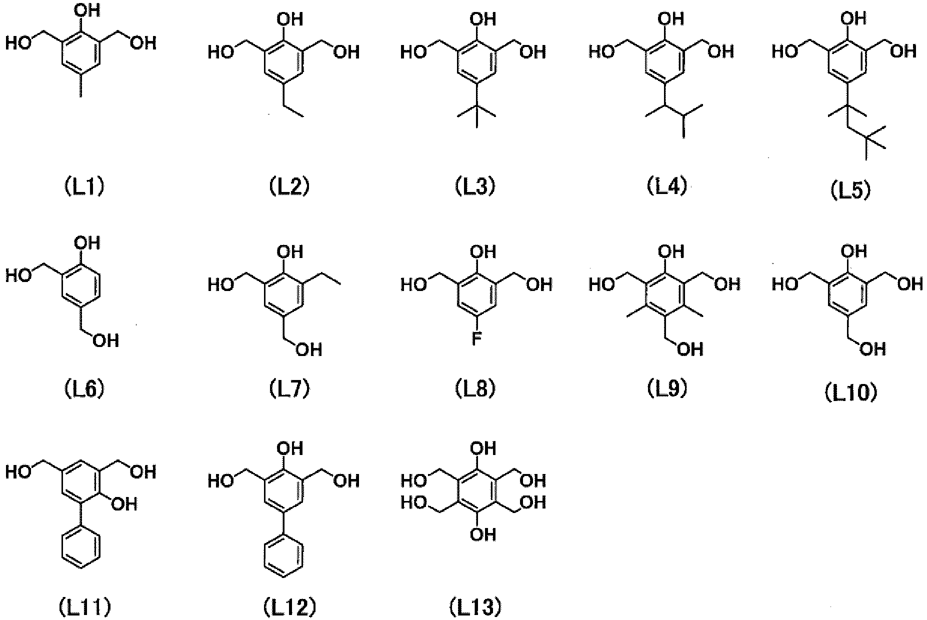

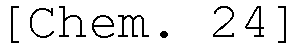

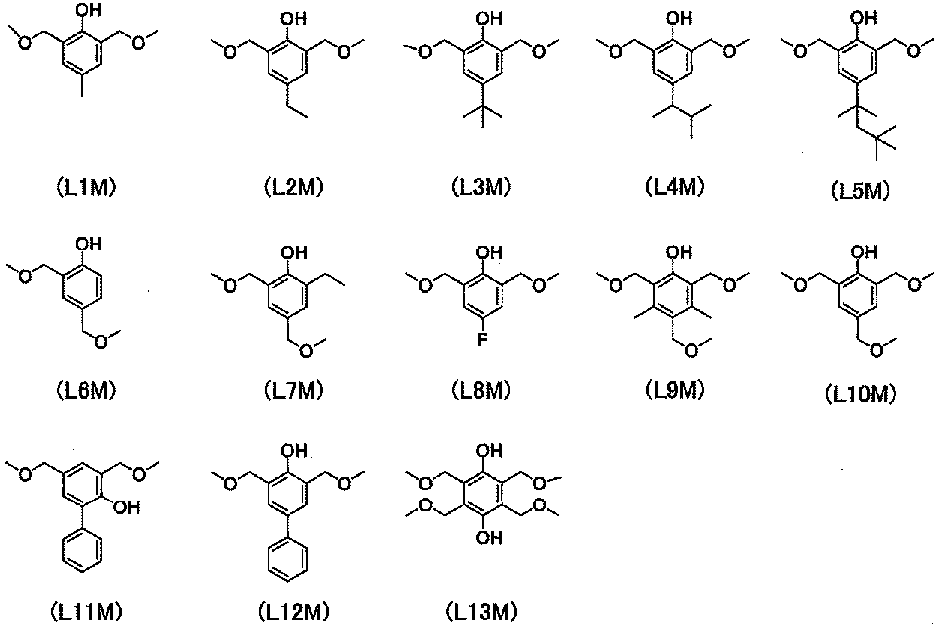

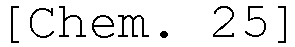

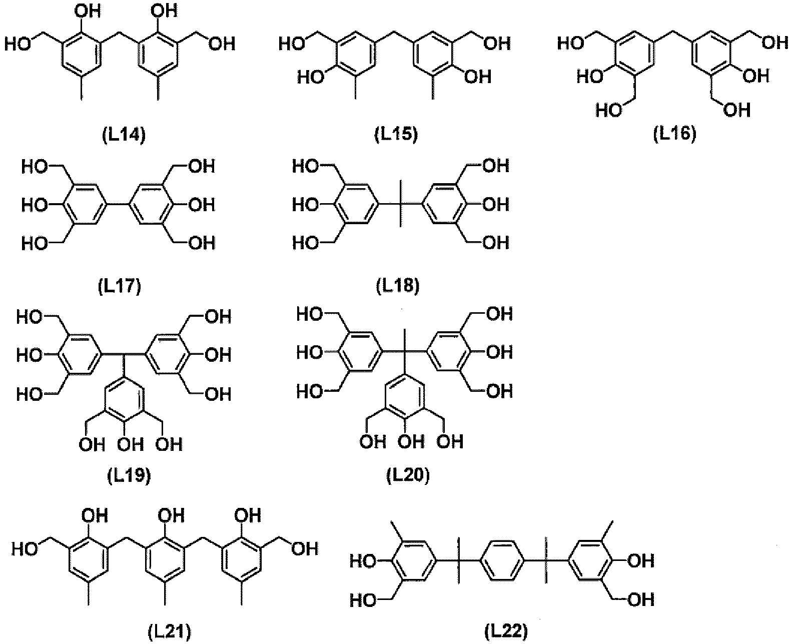

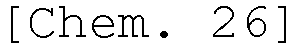

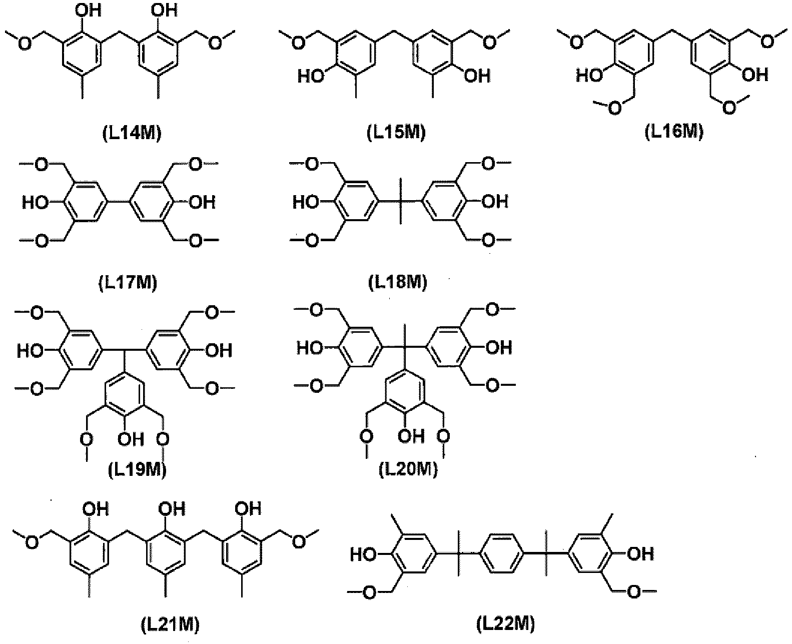

The melamine-based crosslinking agent having a crosslinkable group is a melamine derivative, a 2,4-diamino-1,3,5-triazine derivative, or a 2-amino-1,3,5-triazine derivative in which at least one of hydrogen atoms of an amino group bonded to the triazine ring is substituted with a crosslinkable group, and the triazine ring may further have a substituent such as an aryl group (for example, a phenyl group).

Specific examples of the melamine-based crosslinking agent having a crosslinkable group include, but are not limited to, mono-, bis-, tris-, tetrakis-, pentakis- or hexakisalkoxymethylmelamines such as N,N,N',N',N",N"-hexakis(methoxymethyl)melamine and N,N,N',N',N",N"-hexakis(butoxymethyl)melamine; and mono-, bis-, tris- or tetrakisalkoxymethylbenzoguanamines such as N,N,N',N'-tetrakis(methoxymethyl)benzoguanamine and N,N,N',N'-tetrakis(butoxymethyl)benzoguanamine.

The urea-based crosslinking agent having a crosslinkable group is a derivative of a urea bond-containing compound, and has a structure in which at least one of hydrogen atoms of an NH group constituting a urea bond is substituted with a crosslinkable group.

Specific examples of the urea-based crosslinking agent having a crosslinkable group include, but are not limited to, mono-, bis-, tris-, or tetrakisalkoxymethylglycolurils such as 1,3,4,6-tetrakis(methoxymethyl)glycoluril and 1,3,4,6-tetrakis(butoxymethyl)glycoluril; and mono-, bis-, tris-, or tetrakisalkoxymethylureas such as 1,3-bis(methoxymethyl)urea and 1,1,3,3-tetrakismethoxymethylurea.

The thiourea-based crosslinking agent having a crosslinkable group is a derivative of a thiourea bond-containing compound, and has a structure in which at least one of hydrogen atoms of an NH group constituting a thiourea bond is substituted with a crosslinkable group.

Specific examples of the thiourea-based crosslinking agent having a crosslinkable group include, but are not limited to, mono-, bis-, tris-, or tetrakisalkoxymethylthioureas such as 1,3-bis(methoxymethyl)thiourea and 1,1,3,3-tetrakismethoxymethylthiourea.

The amount of the crosslinking agent contained in the release agent composition varies depending on the coating method to be adopted, the desired film thickness, and the like, and thus cannot be generally specified, but is usually 0.01 to 50 mass% with respect to an organic resin or a polynuclear phenol derivative, and is preferably 0.1 mass% or more, more preferably 1 mass% or more, still more preferably 3 mass% or more, and even more preferably 5 mass% or more, and preferably 45 mass% or less, more preferably 40 mass% or less, still more preferably 35 mass% or less, and even more preferably 30 mass% or less from the viewpoint of achieving suitable curing and obtaining a laminate in which a semiconductor substrate and a support substrate can be favorably separated from each other with high reproducibility.

### <<<<Acid generating agent and acid>>>>

For the purpose of, for example, promoting the crosslinking reaction, the release agent composition may contain an acid generating agent or an acid.

Examples of the acid generating agent include a thermal acid generating agent and a photoacid generating agent.

The thermal acid generating agent is not particularly limited as long as an acid is generated by heat, and specific examples thereof include, but are not limited to, 2,4,4,6-tetrabromocyclohexadienone, benzoin tosylate, 2-nitrobenzyl tosylate, K-PURE [registered trademark] CXC-1612, CXC-1614, TAG-2172, TAG-2179, TAG-2678, TAG2689, and TAG2700 (all are manufactured by King Industries, Inc.), SI-45, SI-60, SI-80, SI-100, SI-110, and SI-150 (manufactured by Sanshin Chemical Industry Co., Ltd.), and other organic sulfonic acid alkyl esters.

Examples of the photoacid generator include onium salt compounds, sulfonimide compounds, and disulfonyl diazomethane compounds.

Specific examples of the onium salt compound include, but are not limited to, iodonium salt compounds such as diphenyliodonium hexafluorophosphate, diphenyliodonium trifluoromethanesulfonate, diphenyliodonium nonafluoronormal butanesulfonate, diphenyliodonium perfluoronormal octanesulfonate, diphenyliodonium camphor sulfonate, bis(4-tert-butylphenyl)iodonium camphor sulfonate, and bis(4-tert-butylphenyl)iodonium trifluoromethanesulfonate; and sulfonium salt compounds such as triphenylsulfonium nitrate, triphenylsulfonium hexafluoroantimonate, triphenylsulfonium nonafluoro-normal butanesulfonate, triphenylsulfonium camphorsulfonate, and triphenylsulfonium trifluoromethanesulfonate.

Specific examples of the sulfonimide compound include, but are not limited to, N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Specific examples of the disulfonyl diazomethane compound include, but are not limited to, bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Specific examples of the acid include, but are not limited to, arylsulfonic acids and pyridinium salts such as p-toluenesulfonic acid, pyridinium p-toluenesulfonate(pyridinium paratoluenesulfonate), pyridinium trifluoromethanesulfonate, pyridinium phenolsulfonic acid, 5-sulfosalicylic acid, 4-phenolsulfonic acid, 4-chlorobenzenesulfonic acid, benzenedisulfonic acid, and 1-naphthalenesulfonic acid, and salts thereof; arylcarboxylic acids such as salicylic acid, benzoic acid, hydroxybenzoic acid, and naphthalenecarboxylic acid, and salts thereof; linear or cyclic alkylsulfonic acids such as trifluoromethanesulfonic acid and camphorsulfonic acid, and salts thereof; and linear or cyclic alkylcarboxylic acids such as citric acid, and salts thereof.

The amounts of the acid generating agent and the acid contained in the release agent composition cannot be generally specified because the amounts vary depending on the type of the crosslinking agent to be used together, the heating temperature at the time of forming the film, and the like, but are usually 0.01 to 5 mass% with respect to the film constituent components.

### <<<<Surfactant>>>>

The release agent composition may contain a surfactant for the purpose of, for example, adjusting the liquid properties of the composition itself or the film properties of the obtained film, or preparing a highly uniform release agent composition with high reproducibility.

Examples of the surfactant may include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkyl aryl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine surfactants such as EFTOP EF301, EF303, and EF352 (manufactured by Tokem Products, trade name), MEGAFACE F171, F173, R-30, and R-30N (manufactured by DIC Corporation, trade name), FLUORAD FC430 and FC431 (manufactured by Sumitomo 3M Ltd., trade name), ASAHIGUARD AG710, SURFLON S-382, SC101, SC102, SC103, SC104, SC105, and SC106 (manufactured by Asahi Glass Co., Ltd., trade name); and organosiloxane polymer KP341 (manufactured by Shin-Etsu Chemical Co., Ltd.).

Surfactants can be used alone or in combination of two or more thereof.

The amount of the surfactant is usually 2 mass% or less with respect to the film constituent components of the release agent composition.

### <<<<Solvent>>>>

The release agent composition preferably contains a solvent.

As such a solvent, it is possible to use, for example, a high-polarity solvent capable of favorably dissolving the film constituent components such as the organic resin, polynuclear phenol derivative, branched polysilane, and crosslinking agent, and it is also possible to use, as necessary, a low-polarity solvent for the purpose of adjusting, for instance, the viscosity and the surface tension. In the present invention, the low-polarity solvent is defined as a solvent having a relative permittivity of less than 7 at a frequency of 100 kHz, and the high-polarity solvent is defined as a solvent having a relative permittivity of 7 or more at a frequency of 100 kHz. The solvents can be used alone or in combination of two or more thereof.

In addition, examples of the high-polarity solvent include amide-based solvents such as N,N-dimethylformamide, N,N-dimethylacetamide, N,N-dimethylisobutyramide, N-methylpyrrolidone, and 1,3-dimethyl-2 imidazolidinone; ketone-based solvents such as ethyl methyl ketone, isophorone, and cyclohexanone; cyano-based solvents such as acetonitrile and 3-methoxypropionitrile; polyhydric alcohol-based solvents such as ethylene glycol, diethylene glycol, triethylene glycol, dipropylene glycol, 1,3-butanediol, and 2,3-butanediol; monohydric alcohol-based solvents other than aliphatic alcohols, such as propylene glycol monomethyl ether, diethylene glycol monomethyl ether, diethylene glycol monophenyl ether, triethylene glycol monomethyl ether, dipropylene glycol monomethyl ether, benzyl alcohol, 2-phenoxyethanol, 2-benzyloxyethanol, 3-phenoxybenzyl alcohol, and tetrahydrofurfuryl alcohol; and sulfoxide-based solvents such as dimethyl sulfoxide.

Examples of the low-polarity solvent include chlorine-based solvents such as chloroform and chlorobenzene; aromatic hydrocarbon-based solvents such as alkylbenzenes (for example, toluene, xylene, tetralin, cyclohexylbenzene, and decylbenzene); aliphatic alcohol-based solvents such as 1-octanol, 1-nonanol, and 1-decanol; ether-based solvents such as tetrahydrofuran, dioxane, anisole, 4-methoxytoluene, 3-phenoxytoluene, dibenzyl ether, diethylene glycol dimethyl ether, diethylene glycol butyl methyl ether, triethylene glycol dimethyl ether, and triethylene glycol butyl methyl ether; and ester-based solvents such as methyl benzoate, ethyl benzoate, butyl benzoate, isoamyl benzoate, bis(2-ethylhexyl)phthalate, dibutyl maleate, dibutyl oxalate, hexyl acetate, propylene glycol monomethyl ether acetate, diethylene glycol monoethyl ether acetate, and diethylene glycol monobutyl ether acetate.

The content of the solvent is appropriately determined in consideration of the desired viscosity of the composition, the coating method to be adopted, the thickness of the film to be prepared, and the like, but is 99 mass% or less with respect to the entire composition, preferably 70 to 99 mass% with respect to the entire composition, that is, the amount of the film constituent components in that case is 1 to 30 mass% with respect to the entire composition.

The viscosity and surface tension of the release agent composition are appropriately adjusted by changing the type of the solvent to be used, the ratio thereof, the concentration of the film constituent components, and the like in consideration of various factors such as the coating method to be used and the desired film thickness.

In one aspect of the present invention, the release agent composition contains a glycol-based solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like. The "glycol-based solvent" as used herein is a generic term for glycols, glycol monoethers, glycol diethers, glycol monoesters, glycol diesters, and glycol ester ethers.

An example of a preferred glycol-based solvent is represented by Formula (G).

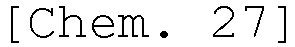

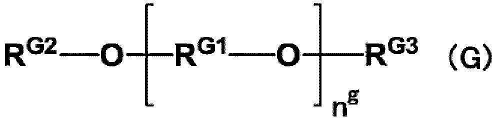

In Formula (G), R^{G1'}s each independently represent a linear or branched alkylene group having 2 to 4 carbon atoms, R^{G2} and R^{G3} each independently represent a hydrogen atom, a linear or branched alkyl group having 1 to 8 carbon atoms, or an alkylacyl group in which the alkyl moiety is a linear or branched alkyl group having 1 to 8 carbon atoms, and n^{g} is an integer of 1 to 6.

Specific examples of the linear or branched alkylene group having 2 to 4 carbon atoms include, but are not limited to, an ethylene group, a trimethylene group, a 1-methylethylene group, a tetramethylene group, a 2-methylpropane-1,3-diyl group, a pentamethylene group, and a hexamethylene group.

Among them, a linear or branched alkylene group having 2 to 3 carbon atoms is preferable, and a linear or branched alkylene group having 3 carbon atoms is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms include, but are not limited to, a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group.

Among them, a methyl group and an ethyl group are preferable, and a methyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

Specific examples of the linear or branched alkyl group having 1 to 8 carbon atoms in the alkylacyl group in which the alkyl moiety is a linear or branched alkyl group having 1 to 8 carbon atoms include the same as the specific examples described above.

Among them, a methylcarbonyl group and an ethylcarbonyl group are preferable, and a methylcarbonyl group is more preferable from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

n^{g} is preferably 4 or less, more preferably 3 or less, still more preferably 2 or less, most preferably 1 from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In Formula (G), preferably, at least one of R^{G2} and R^{G3} is a linear or branched alkyl group having 1 to 8 carbon atoms, more preferably, one of R^{G2} and R^{G3} is a linear or branched alkyl group having 1 to 8 carbon atoms and the other is an alkylacyl group in which a hydrogen atom or an alkyl moiety is a linear or branched alkyl group having 1 to 8 carbon atoms from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The content of the glycol-based solvent is preferably 50 mass% or more, more preferably 70 mass% or more, still more preferably 80 mass% or more, even more preferably 90 mass% or more, and even more preferably 95 mass% or more with respect to the solvent contained in the release agent composition from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

In the release agent composition, the film constituent components are uniformly dispersed or dissolved, preferably dissolved in the solvent from the viewpoint of obtaining a highly uniform composition with good reproducibility, from the viewpoint of obtaining a highly storage-stable composition with good reproducibility, from the viewpoint of obtaining a composition that provides a highly uniform film with good reproducibility, and the like.

The release agent composition can be produced, for example, by mixing an organic resin or a polynuclear phenol derivative, a solvent, and, as necessary, a crosslinking agent.

The mixing order is not particularly limited, but examples of the method for easily producing the release agent composition with good reproducibility include, but are not limited to, a method in which an organic resin or a polynuclear phenol derivative and a crosslinking agent are dissolved at a time in a solvent, and a method in which parts of an organic resin or a polynuclear phenol derivative and a crosslinking agent are dissolved in a solvent, the rest is separately dissolved in a solvent, and each obtained solution is mixed. In addition, when the release agent composition is prepared, the components may be appropriately heated as long as the components are not decomposed or altered.

In the present invention, for the purpose of removing foreign matter, a solvent, a solution, or the like to be used may be filtered using a filter or the like during the production of the release agent composition or after mixing all the components.

The thickness of the release agent layer is not particularly limited, but is usually 5 nm to 100 µm, 10 nm to 10 um in one aspect, 50 nm to 1 µm in another aspect, and 100 nm to 700 nm in still another aspect.

The method for forming the release agent layer from the release agent composition is not particularly limited, but examples thereof include a method for forming the release agent layer by applying the release agent composition.

The coating method for the release agent composition is not particularly limited, but is usually a spin coating method.

The heating temperature of the applied release agent composition varies depending on the type and amount of the release agent component contained in the release agent composition, the desired thickness of the release agent layer, and the like, and thus cannot be generally specified, but from the viewpoint of achieving a suitable release agent layer with good reproducibility, the heating temperature is 80°C to 300°C, and the heating time is appropriately determined usually in the range of 10 seconds to 10 minutes depending on the heating temperature. The heating temperature is preferably 100°C to 280°C, and more preferably 150°C to 250°C. The heating time is preferably 30 seconds to 8 minutes, and more preferably 1 minute to 5 minutes.

The heating can be performed using a hot plate, an oven, or the like.

Hereinafter, an example of the configuration of the laminate of the first embodiment will be described with reference to a drawing.

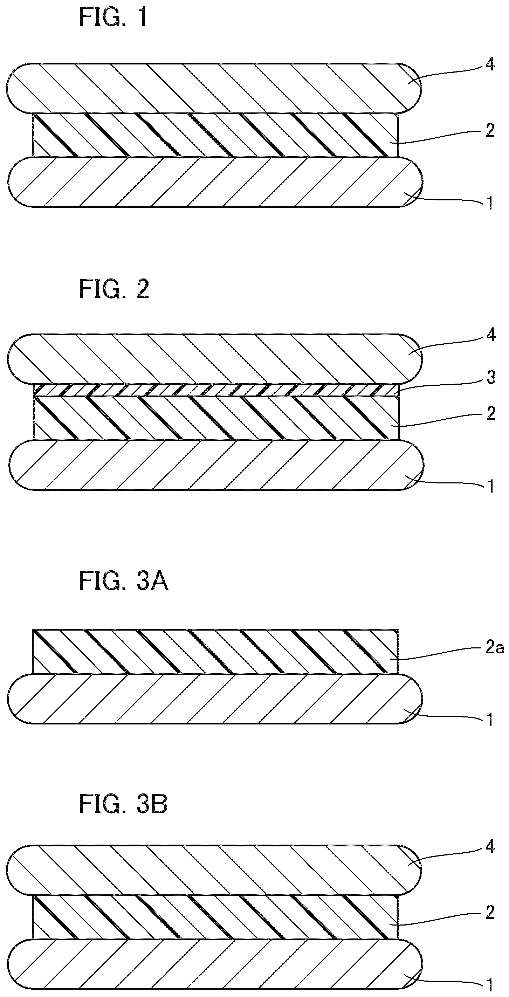

Fig. 1 shows a schematic cross-sectional view of an example of the laminate of the first embodiment.

The laminate of Fig. 1 includes a semiconductor substrate 1, an adhesive layer 2, and a support substrate 4 in this order. In other words, the adhesive layer 2 is provided between the semiconductor substrate 1 and the support substrate 4. The adhesive layer 2 is in contact with the semiconductor substrate 1 and the support substrate 4.

Hereinafter, another example of the configuration of the laminate of the first embodiment will be described with reference to a drawing.

Fig. 2 shows a schematic cross-sectional view of another example of the laminate of the first embodiment.

The laminate of Fig. 2 includes a semiconductor substrate 1, an adhesive layer 2, a release agent layer 3, and a support substrate 4 in this order.

The adhesive layer 2 and the release agent layer 3 are provided between the semiconductor substrate 1 and the support substrate 4. The adhesive layer 2 is in contact with the semiconductor substrate 1. The release agent layer 3 is in contact with the adhesive layer 2 and the support substrate 4.

### <<Method for producing one example of laminate according to first embodiment>>

A method for producing a laminate will be described below with the laminate shown in Fig. 1 as an example of the laminate according to the first embodiment.

An example of the laminate of the present invention can be produced, for example, by a method including the following Steps 1 and 2.
Step 1: a step of applying an adhesive composition onto a semiconductor substrate to form an adhesive coating layer
Step 2: a step of heating the adhesive coating layer to form an adhesive layer

The coating method for the adhesive composition is not particularly limited, but is usually a spin coating method. A method for separately forming a coating film by a spin coating method or the like, forming a sheet-like coating film, and sticking the sheet-like coating film as an adhesive coating layer can be adopted.

The heating temperature of the applied adhesive composition varies depending on the type and amount of the adhesive component contained in the adhesive composition, whether or not a solvent is contained, the boiling point of the solvent used, the desired thickness of the adhesive layer, and the like, and thus cannot be generally specified, but the heating temperature is usually 80°C to 150°C, and the heating time is usually 30 seconds to 5 minutes.

When the adhesive composition contains a solvent, the applied adhesive composition is usually heated.

The film thickness of an adhesive coating layer obtained by applying an adhesive composition and heating the adhesive composition, if necessary, is usually about 5 to 500 µm, and is ultimately determined appropriately to fall within the above-described range of the thickness of the adhesive layer.

In the present invention, the laminate of the present invention can be obtained by applying a load in the thickness direction of the semiconductor substrate and the support substrate while performing heat treatment or decompression treatment or both thereof, and then performing post-heat treatment. The treatment conditions to be adopted, whether heat treatment, decompression treatment, or a combination of both, are appropriately determined taking into consideration various factors such as the type of adhesive composition, the film thickness, and the desired adhesive strength.

The heat treatment is appropriately determined from the range of usually 20°C to 160°C from the viewpoint of removing the solvent from the composition, and the like. In particular, from the viewpoint of suppressing or avoiding excessive curing and unnecessary alteration of the adhesive component (A), the heating temperature is preferably 150°C or lower and more preferably 130°C or lower, and the heating time is appropriately determined depending on the heating temperature and the type of the adhesive. However, from the viewpoint of reliably exhibiting suitable adhesion, the heating time is usually 30 seconds or longer and preferably 1 minute or longer. From the viewpoint of suppressing alteration of the adhesive layer and other members, the heating time is usually 10 minutes or shorter and preferably 5 minutes or shorter.

In the decompression treatment, the adhesive coating layers in contact with each other may be exposed to an atmospheric pressure of 10 to 10,000 Pa. The time for the decompression treatment is usually 1 to 30 minutes.

The load in the thickness direction of the semiconductor substrate and the support substrate is not particularly limited as long as the load does not adversely affect the semiconductor substrate, the support substrate, and the layer therebetween, and can bring them into close contact with each other, but is usually within the range of 10 to 50,000 N.

The post-heating temperature is preferably 120°C or higher from the viewpoint of achieving a sufficient curing rate and the like, and is preferably 260°C or lower from the viewpoint of preventing alteration of the substrates and each layer, and the like.

The post-heating time is usually 1 minute or longer and preferably 5 minutes or longer from the viewpoint of achieving suitable bonding of the substrates and the layers constituting the laminate, and is usually 180 minutes or shorter and preferably 120 minutes or shorter from the viewpoint of suppressing or avoiding an adverse effect on each layer due to excessive heating, and the like.

Heating can be performed using a hot plate, an oven, or the like. In a case where post-heating is performed using a hot plate, heating may be performed with either the semiconductor substrate or the support substrate of the laminate facing down. Preferably, post-heating is performed with the semiconductor substrate facing down from the viewpoint of achieving suitable release with good reproducibility.

One object of the post-heat treatment is to realize an adhesive layer as a more suitable self-standing film, and particularly to suitably achieve curing by a hydrosilylation reaction.

Figs. 3A to 3C are views for illustrating one aspect of producing a laminate.

First, a laminate in which an adhesive coating layer 2a is formed on the semiconductor substrate 1 is prepared (Fig. 3A). This laminate can be obtained, for example, by applying the adhesive composition onto the semiconductor substrate 1, followed by heating.

Next, the laminate shown in Fig. 3A and the support substrate 4 are bonded to each other such that the adhesive coating layer 2a and the support substrate 4 are in contact with each other. Then, after a load is applied in the thickness direction between the semiconductor substrate 1 and the support substrate 4 under reduced pressure, a heating device (not shown; a hot plate) is disposed on the surface of the semiconductor substrate 1 on a side opposite to a surface in contact with the adhesive coating layer 2a, and the adhesive coating layer 2a is heated and cured by the heating device to be converted into the adhesive layer 2 (Fig. 3B).

The laminate shown in Fig. 1 is obtained by the steps shown in Figs. 3A and 3B.

### <Second embodiment>

A laminate having an electronic device layer is used for processing of the electronic device layer. While the electronic device layer is being processed, the electronic device layer is adhered to a support substrate. After processing the electronic device layer, the electronic device layer is separated from the support substrate.

### <<Electronic device layer>>

The electronic device layer refers to a layer having an electronic device, and in the present invention, refers to a layer in which a plurality of semiconductor chip substrates are embedded in a sealing resin, that **is, a** layer including a plurality of semiconductor chip substrates and a sealing resin disposed between the semiconductor chip substrates.

Here, the "electronic device" means a member constituting at least a part of an electronic component. The electronic device is not particularly limited, but can be one in which various mechanical structures and circuits are formed on the surface of a semiconductor substrate. The electronic device is preferably a composite of a member made of metal or a semiconductor and a resin that seals or insulates the member. The electronic device may be one in which a rewiring layer, which will be described below, and/or a semiconductor element or other elements are sealed or insulated with a sealing material or an insulating material, and has a single-layer or multi-layer structure.

### <<Support substrate>>

As the support substrate, those similar to those described in the section of <<Support substrate>> above of <First embodiment> above are exemplified.

### <<Release agent layer>>

The release agent layer is formed using the release agent composition for release by irradiation with light of the present invention described above.

The detailed description of the release agent layer is as described in the section of <<Release agent layer>> above of <First embodiment> above.

### <<Adhesive layer>>

The adhesive layer is formed using the adhesive composition described above.

The detailed description of the adhesive layer is as described in the section of <<Adhesive layer>> above of <First embodiment> above.

Hereinafter, an example of the configuration of the laminate of the second embodiment will be described with reference to the drawings.

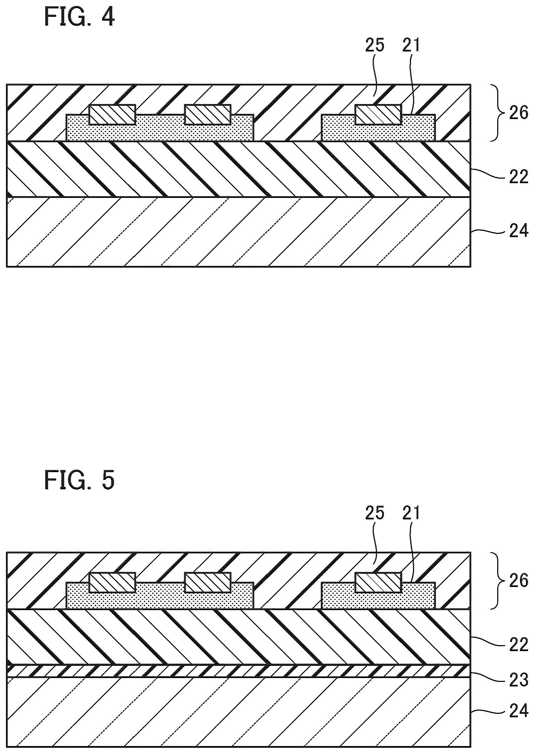

The laminate in Fig. 4 includes a support substrate 24, an adhesive layer 22, and an electronic device layer 26 in this order.

The electronic device layer 26 includes a plurality of semiconductor chip substrates 21 and a sealing resin 25 which is a sealing material disposed between the semiconductor chip substrates 21.

The adhesive layer 22 is provided between the electronic device layer 26 and the support substrate 24. The adhesive layer 22 is in contact with the electronic device layer 26 and the support substrate 24.

Fig. 5 shows a schematic cross-sectional view of another example of the laminate of the second embodiment.

The laminate of Fig. 5 includes a support substrate 24, a release agent layer 23, an adhesive layer 22, and an electronic device layer 26 in this order.

The electronic device layer 26 includes a plurality of semiconductor chip substrates 21 and a sealing resin 25 which is a sealing material disposed between the semiconductor chip substrates 21.

The adhesive layer 22 and the release agent layer 23 are provided between the electronic device layer 26 and the support substrate 24. The adhesive layer 22 is in contact with the electronic device layer 26. The release agent layer 23 is in contact with the adhesive layer 22 and the support substrate 24.

### <<Method for producing one example of laminate according to second embodiment>>

A method for producing a laminate will be described below with the laminate shown in Fig. 4 as an example of the laminate according to the second embodiment.

The laminate of the present invention can be produced, for example, by a method including the following Steps 1 to 4.

Step 1: a step of applying an adhesive composition onto a surface of the above support substrate to form an adhesive coating layer (if necessary, further heating is performed to form an adhesive layer)

Step 2: a step of placing a semiconductor chip substrate on the adhesive coating layer or the adhesive layer, and bonding the semiconductor chip substrate to the adhesive coating layer or the adhesive layer while performing at least one of heat treatment and decompression treatment

Step 3: a step of curing the adhesive coating layer by post-heat treatment to form an adhesive layer

Step 4: a step of sealing the semiconductor chip substrate fixed onto the adhesive layer using a sealing resin

To describe Step 2 in more detail, for example, the following Step (i) of the embodiment may be exemplified.
(i) The semiconductor chip substrate is placed on the adhesive coating layer or the adhesive layer, and while at least one of the heat treatment and the decompression treatment is performed, a load is applied in the thickness direction of the semiconductor chip substrate and the support substrate to bring the semiconductor chip substrate and the support substrate into close contact with each other, and the semiconductor chip substrate is bonded to the adhesive coating layer or the adhesive layer.

Step 3 may be performed after the semiconductor chip substrate in Step 2 is bonded to the adhesive coating layer, or may be performed in combination with Step **2.** For example, by placing the semiconductor chip substrate on the adhesive coating layer and heating and curing the adhesive coating layer while applying a load in the thickness direction of the semiconductor chip substrate and the support substrate, adhesion between the semiconductor chip substrate and the adhesive coating layer and curing from the adhesive coating layer to the adhesive layer may be performed together to bond the adhesive layer and the semiconductor chip substrate to each other.

In addition, Step 3 may be performed before Step 2, the semiconductor chip substrate may be placed on the adhesive layer, and while a load is applied in the thickness direction of the semiconductor chip substrate and the support substrate, the adhesive layer and the semiconductor chip substrate may be bonded to each other.

The coating method, the heating temperature of the applied adhesive composition, the heating means, and the like are as described in <<Method for producing one example of laminate according to first embodiment>> above of <First embodiment> above.

Hereinafter, the procedure of the method for producing the laminate of the second embodiment will be described in more detail with reference to the drawings. In this production method, the laminate shown in Fig. 4 is produced.

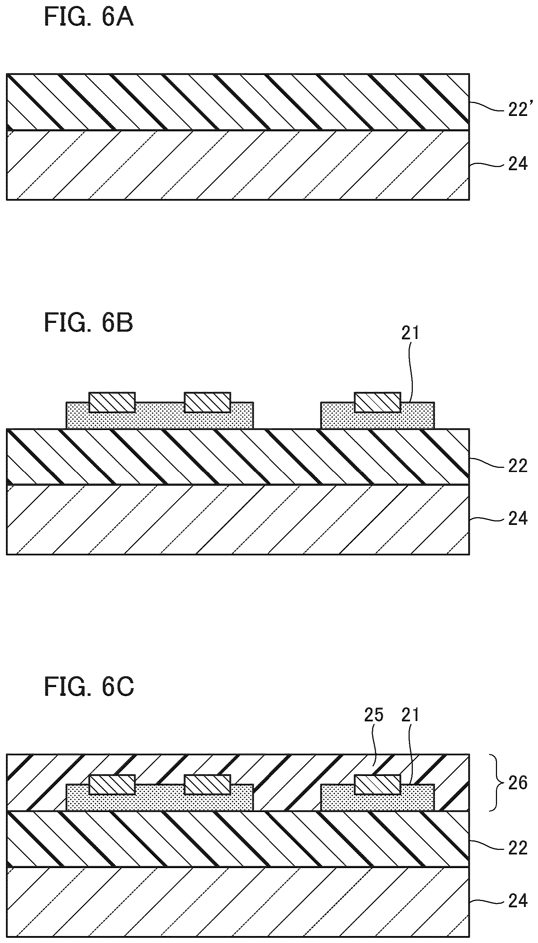

As shown in Fig. 6A, an adhesive coating layer 22' made of the adhesive composition is formed on a support substrate 24. At that time, the adhesive coating layer 22' may be heated to form an adhesive layer 22.

Next, as shown in Fig. 6B, a semiconductor chip substrate 21 is placed on the adhesive layer 22 or the adhesive coating layer 22', and while at least one of the heat treatment and the decompression treatment is performed, a load is applied in the thickness direction of the semiconductor chip substrate 21 and the support substrate 24 to bring the semiconductor chip substrate 21 and the support substrate 24 into close contact with each other, and the semiconductor chip substrate 21 is bonded to the adhesive layer 22 or the adhesive coating layer 22'. When the semiconductor chip substrate 21 is bonded to the adhesive coating layer 22', the adhesive coating layer 22' is cured by post-heat treatment to form the adhesive layer 22, and the semiconductor chip substrate 21 is fixed to the adhesive layer 22.

Next, as shown in Fig. 6C, the semiconductor chip substrate 21 fixed onto the adhesive layer 22 is sealed using a sealing resin 25. In Fig. 6C, the plurality of semiconductor chip substrates 21 temporarily adhered onto the support substrate 24 via the adhesive layer 22 is sealed with the sealing resin 25. An electronic device layer 26, which includes the semiconductor chip substrates 21 and the sealing resin 25 between the semiconductor chip substrates 21, is formed on the adhesive layer 22. In this manner, the electronic device layer 26 is a base material layer in which a plurality of semiconductor chip substrates are embedded in a sealing resin.

### <<<Sealing step>>>

The semiconductor chip substrate 21 is sealed using a sealing material.

As the sealing material for sealing the semiconductor chip substrate 21, a member capable of insulating or sealing a member made of metal or a semiconductor is used.

In the present invention, for example, a resin composition (sealing resin) is used as the sealing material. The type of the sealing resin is not particularly limited as long as the sealing resin can seal and/or insulate metal or a semiconductor, but for example, an epoxy-based resin or a silicone-based resin is preferably used.

The sealing material may contain, in addition to the resin component, other components such as a filler. Examples of the filler include spherical silica particles.

In the sealing step, for example, the sealing resin heated to 130°C to 170°C is supplied onto the adhesive layer 22 to cover the semiconductor chip substrate 21 while maintaining a high viscosity state, and is compression-molded to form a layer including the sealing resin 25 on the adhesive layer 22. At this time, the temperature condition is, for example, 130°C to 170°C. In addition, the pressure applied to the semiconductor chip substrate 21 is, for example, 50 to 500 N/cm².

### (Method for manufacturing processed semiconductor substrate or electronic device layer)

When the laminate according to the present invention is used, a method for manufacturing a processed semiconductor substrate or a method for manufacturing a processed electronic device layer can be provided.

In the "method for manufacturing a processed semiconductor substrate," the laminate described in the section of <First embodiment> above of (Laminate) above is used. In addition, in the "method for manufacturing a processed electronic device layer," the laminate described in the section of <Second embodiment> above of (Laminate) above is used.

The "method for manufacturing a processed semiconductor substrate" will be described in <Third embodiment> below, and the "method for manufacturing a processed electronic device layer" will be described in <Fourth embodiment> below.

### <Third embodiment>

The method for manufacturing a processed semiconductor substrate of the present invention includes the following Step 5A and the following Step 6A. The method for manufacturing a processed electronic device layer may further include the following Step 7A.

Here, Step 5A is a step of processing the semiconductor substrate in the laminate described in the section of

### <First embodiment> above.

In addition, Step 6A is a step of separating the semiconductor substrate processed in Step 5A and the support substrate from each other.

In addition, Step 7A is a step of cleaning the processed semiconductor substrate after Step 6A.

The processing performed on the semiconductor substrate in Step 5A is, for example, processing on the side opposite to the circuit surface of the wafer, and includes thinning of the wafer by polishing the back surface of the wafer. Thereafter, for example, a through-silicon via (TSV) or the like is formed, and then the thinned wafer is released from the support substrate to form a laminate of wafers which are three-dimensionally mounted. In addition, for example, before and after that, a wafer back surface electrode and the like are also formed. In addition, for example, the thinned semiconductor substrate and another semiconductor element (For example, DRAM) are connected in a state where the semiconductor substrate is supported on the support substrate via an adhesive layer. At this time, for example, heat of about 250°C to 350°C may be applied for a long period of time. In addition, during the wafer thinning and TSV processes, heat of about 250°C to 350°C is applied while adhesion to the support substrate is maintained. The laminate of the present invention usually includes the adhesive layer to provide heat resistance to the load.

The processing is not limited to the above-described processing, and includes, for example, implementation of a process of mounting a semiconductor component in a case where the semiconductor component is temporarily adhered to the support substrate in order to support a base material for mounting the semiconductor component.

In Step 6A, the method for separating (releasing) the semiconductor substrate from the support substrate is not particularly limited.

For example, there is a method in which mechanical release is performed with equipment having a sharp portion (so-called a debonder). Specifically, for example, after the sharp portion is inserted between the semiconductor substrate and the support substrate, the semiconductor substrate and the support substrate are separated from each other.

In addition, when the laminate has a release agent layer, the method for separating (releasing) the semiconductor substrate from the support substrate in step 6A may be releasing by peeling between semiconductor substrate and the support substrate after the release agent layer is irradiated with light, and the like.

By irradiating the release agent layer with light from the support substrate side, the release agent layer is altered (for example, the release agent layer is separated or decomposed) as described above, and thereafter, for example, one of the substrates is pulled up, and the semiconductor substrate and the support substrate can be easily separated from each other.

The release agent layer is not necessarily irradiated with light over the entire region of the release agent layer. Even when the region irradiated with light and the region not irradiated with light are mixed, the semiconductor substrate and the support substrate can be separated from each other, for example, by a slight external force such as pulling up of the support substrate as long as the release agent layer as a whole has sufficiently improved releasing ability. The ratio and positional relationship between the region irradiated with light and the region not irradiated with light vary depending on the type and specific composition of the adhesive to be used, the thickness of the adhesive layer, the thickness of the adhesive layer, the thickness of the release agent layer, the intensity of light to be emitted, and the like, but those skilled in the art can appropriately set conditions without requiring an excessive test. For such circumstances, according to the method for manufacturing a processed semiconductor substrate of the present invention, for example, in a case where the support substrate of the laminate to be used is light-transmissive, it is possible to shorten the irradiation time with light when release is performed by irradiation with light from the support substrate side, and as a result, not only improvement in throughput can be expected, but also physical stress and the like required for release can be avoided, and the semiconductor substrate and the support substrate can be easily and efficiently separated from each other only by irradiation with light.

The light irradiation dose required for release is usually 50 to 3,000 mJ/cm². The irradiation time is appropriately determined depending on the wavelength and the irradiation dose.

The wavelength of light used for release is preferably, for example, a wavelength of 250 to 600 nm, and more preferably a wavelength of 250 to 370 nm. A more suitable wavelength is 308 nm, 343 nm, 355 nm, 365 nm, or 532 nm. The light irradiation dose required for release is an irradiation dose that can cause suitable alteration, for example, decomposition of the specific compound and polymer.

The light used for release may be laser light or non-laser light emitted from a light source such as an ultraviolet lamp.

The substrates can be cleaned by spraying a cleaning agent composition onto the surface of at least one of the separated semiconductor substrate and the separated support substrate, or by immersing the separated semiconductor substrate or the separated support substrate in a cleaning agent composition.

In addition, the surface of the processed semiconductor substrate or the like may be cleaned using a removal tape or the like.

As an example of cleaning the substrates, Step 7A of cleaning the processed semiconductor substrate may be performed after Step 6A.

Examples of the cleaning agent composition to be used for cleaning include the following.

The cleaning agent composition usually contains a solvent.

Examples of the solvent include lactones, ketones, polyhydric alcohols, compounds having an ester bond, derivatives of polyhydric alcohols, cyclic ethers, esters, and aromatic organic solvents.

Examples of the lactones include γ-butyrolactone.

Examples of the ketones include acetone, methyl ethyl ketone, cyclohexanone, methyl-n-pentyl ketone, methyl isopentyl ketone, and 2-heptanone.

Examples of the polyhydric alcohols include ethylene glycol, diethylene glycol, propylene glycol, and dipropylene glycol.

Examples of the compounds having an ester bond include ethylene glycol monoacetate, diethylene glycol monoacetate, propylene glycol monoacetate, and dipropylene glycol monoacetate.

Examples of the derivatives of polyhydric alcohols include compounds having an ether bond such as monophenyl ethers or monoalkyl ethers, such as monomethyl ether, monoethyl ether, monopropyl ether, and monobutyl ether, of the above polyhydric alcohols or of the above compounds having an ester bond. Among them, propylene glycol monomethyl ether acetate (PGMEA) and propylene glycol monomethyl ether (PGME) are preferable.

Examples of the cyclic ethers include dioxane.

Examples of the esters include methyl lactate, ethyl lactate (EL), methyl acetate, ethyl acetate, butyl acetate, methyl pyruvate, ethyl pyruvate, methyl methoxypropionate, and ethyl ethoxypropionate.

Examples of the aromatic organic solvents include anisole, ethyl benzyl ether, cresyl methyl ether, diphenyl ether, dibenzyl ether, phenetole, butyl phenyl ether, ethylbenzene, diethylbenzene, pentylbenzene, isopropylbenzene, toluene, xylene, cymene, and mesitylene.

These can be used alone or in combination of two or more thereof.

Among them, propylene glycol monomethyl ether acetate (PGMEA), propylene glycol monomethyl ether (PGME), cyclohexanone, and ethyl lactate (EL) are preferable.

In addition, a mixed solvent obtained by mixing PGMEA and a polar solvent is also preferable. The blending ratio (mass ratio) may be appropriately determined in consideration of compatibility between PGMEA and the polar solvent, or the like, and is preferably in the range of 1:9 to 9:1, more preferably 2:8 to 8:2.

For example, when EL is blended as the polar solvent, the mass ratio of PGMEA:EL is preferably 1:9 to 9:1, more preferably 2:8 to 8:2. In addition, when PGME is blended as the polar solvent, the mass ratio of PGMEA:PGME is preferably 1:9 to 9:1, more preferably 2:8 to 8:2, still more preferably 3:7 to 7:3. In addition, when PGME and cyclohexanone are blended as the polar solvent, the mass ratio of PGMEA: (PGME + cyclohexanone) is preferably 1:9 to 9:1, more preferably 2:8 to 8:2, still more preferably 3:7 to 7:3.

The cleaning agent composition may or may not contain a salt, but it is preferable that the cleaning agent composition do not contain a salt from the viewpoint of enhancing versatility in processing a semiconductor substrate using a laminate and reducing costs.

An example of the case where the cleaning agent composition contains a salt includes a cleaning agent composition containing a quaternary ammonium salt and a solvent.

The quaternary ammonium salt is composed of a quaternary ammonium cation and an anion, and is not particularly limited as long as the quaternary ammonium salt is used for this type of application.

Such quaternary ammonium cations typically include tetra (hydrocarbon) ammonium cations. On the other hand, examples of an anion paired therewith include, but are not limited to, a hydroxide ion (OH⁻); a halogen ion such as a fluorine ion (F⁻), a chlorine ion (Cl⁻), a bromine ion (Br⁻), and an iodine ion (I⁻); a tetrafluoroborate ion (BF₄⁻) ; and a hexafluorophosphate ion (PF₆⁻).

The quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferred aspect, the fluorine-containing quaternary ammonium salt is tetra(hydrocarbon)ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride contains tetraalkylammonium fluoride.

Specific examples of tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferable.

As the quaternary ammonium salt such as tetra(hydrocarbon)ammonium fluoride, a hydrate may be used. In addition, the quaternary ammonium salts such as tetra(hydrocarbon)ammonium fluoride may be used alone or in combination of two or more thereof.

The amount of the quaternary ammonium salt is not particularly limited as long as the quaternary ammonium salt dissolves in the solvent contained in the cleaning agent composition, but is usually 0.1 to 30 mass% with respect to the cleaning agent composition.

When the cleaning agent composition contains a salt, the solvent to be used in combination is not particularly limited as long as the solvent is used for this type of application and dissolves a salt such as a quaternary ammonium salt, but from the viewpoint of obtaining a cleaning agent composition having excellent cleanability with good reproducibility, from the viewpoint of obtaining a cleaning agent composition having excellent uniformity by favorably dissolving a salt such as a quaternary ammonium salt, and the like, the cleaning agent composition preferably contains one or two or more amide-based solvents.

Suitable examples of the amide-based solvents include an acid amide derivative represented by Formula (Z).

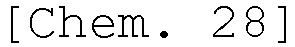

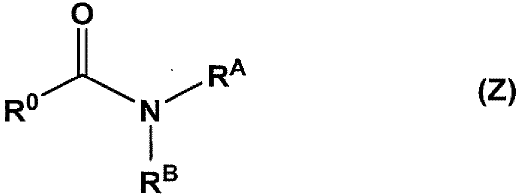

In the formula, R⁰ represents an ethyl group, a propyl group or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, an n-butyl group, an isobutyl group, an s-butyl group, a t-butyl group, and a cyclobutyl group. Among them, R^{A} and R^{B} are preferably a methyl group or an ethyl group, more preferably a methyl group or an ethyl group, and still more preferably a methyl group.

Examples of the acid amide derivative represented by Formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Among them, in particular, N,N-dimethylpropionamide and N,N-dimethylisobutyramide are preferable, and N,N-dimethylpropionamide is more preferable.

The acid amide derivative represented by Formula (Z) may be synthesized by a substitution reaction between a corresponding carboxylic acid ester and an amine, or a commercially available product may be used.

Another example of the preferred amide-based solvents includes a lactam compound represented by Formula (Y).

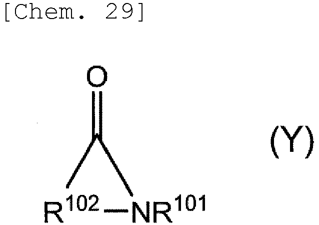

In Formula (Y), R¹⁰¹ represents a hydrogen atom or an alkyl group having 1 to 6 carbon atoms, and R¹⁰² represents an alkylene group having 1 to 6 carbon atoms. Specific examples of the alkyl group having 1 to 6 carbon atoms include a methyl group, an ethyl group, an n-propyl group, and an n-butyl group, and specific examples of the alkylene group having 1 to 6 carbon atoms include, but are not limited to, a methylene group, an ethylene group, a trimethylene group, a tetramethylene group, a pentamethylene group, and a hexamethylene group.

Specific examples of the lactam compound represented by Formula (Y) may include an α-lactam compound, a β-lactam compound, a γ-lactam compound, and a δ-lactam compound, and these compounds can be used alone or in combination of two or more thereof.

In a preferred aspect, the lactam compound represented by Formula (Y) contains 1-alkyl-2-pyrrolidone (N-alkyl-γ-butyrolactam), in a more preferred aspect, it contains N-methylpyrrolidone (NMP) or N-ethylpyrrolidone (NEP), and in a still more preferred aspect, it contains N-methylpyrrolidone (NMP).

The cleaning agent composition used in the present invention may contain water as the solvent, but usually, only an organic solvent is intended to be used as the solvent, for example, from the viewpoint of avoiding corrosion of the substrates and the like. In this case, it is not denied that hydrated water of the salt or trace amounts of water contained in the organic solvent is contained in the cleaning agent composition. The water content of the cleaning agent composition used in the present invention is usually 5 mass% or less.

The constituent elements and method elements relating to the above-described steps of the method for manufacturing a processed semiconductor substrate of the present invention may be variously changed without departing from the gist of the present invention.

The method for manufacturing a processed semiconductor substrate of the present invention may include steps other than the above-described steps.

As an example of the releasing method of the present invention, when the semiconductor substrate or the support substrate of the laminate of the present invention is light-transmissive, the semiconductor substrate and support substrate of the laminate are separated from each other by irradiating the release agent layer with light from the semiconductor substrate side or the support substrate side.

In an example of the laminate of the present invention, since the semiconductor substrate and the support substrate are temporarily adhered to each other by the adhesive layer and the release agent layer to be suitably releasable, for example, when the support substrate is light-transmissive, the semiconductor substrate and the support substrate can be easily separated from each other by irradiating the release agent layer with light from the support substrate side of the laminate. Usually, release is performed after the semiconductor substrate of the laminate is processed.

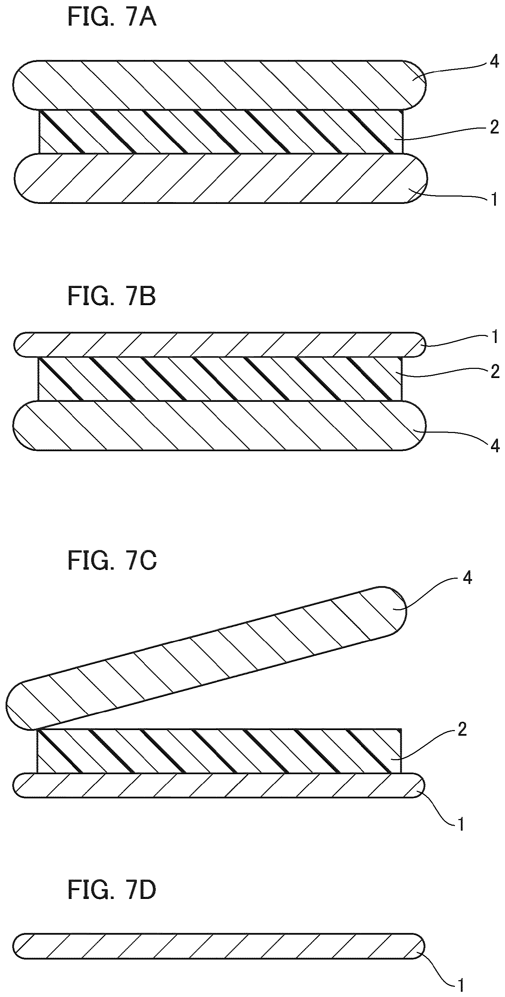

An example of the third embodiment will be described with reference to Figs. 7A to 7D. This example is an example of manufacturing a thinned semiconductor substrate.

First, a laminate is prepared (Fig. 7A). This laminate is the same laminate as the laminate shown in Figs. 1 and 3B.

Next, the surface of the semiconductor substrate 1 on a side opposite to a surface in contact with the adhesive layer 2 is polished using a polishing apparatus (not shown) to thin the semiconductor substrate 1 (Fig. 7B). Formation of through-electrodes and similar processes may be formed on the thinned semiconductor substrate 1.

Next, the thinned semiconductor substrate 1 and the support substrate 4 are separated from each other using a releasing device (not shown) (Fig. 7C).

Then, the thinned semiconductor substrate 1 is obtained (Fig. 7D).

Here, residues of the adhesive layer 2 may remain on the thinned semiconductor substrate 1. Accordingly, it is preferable to clean the thinned semiconductor substrate 1 using the cleaning agent composition to remove the residues of the adhesive layer 2 from the semiconductor substrate 1.

### <Fourth embodiment>

The method for manufacturing a processed electronic device layer of the present invention includes the following Step 5B and the following Step 6B. The method for manufacturing a processed electronic device layer may further include the following Step 7B.

Here, Step 5B is a step of processing the electronic device layer in the laminate described in the section of <Second embodiment> above.

In addition, Step 6B is a step of separating the electronic device layer processed in Step 5B from the support substrate.

In addition, Step 7B is a step of cleaning the processed electronic device layer after Step 6B.

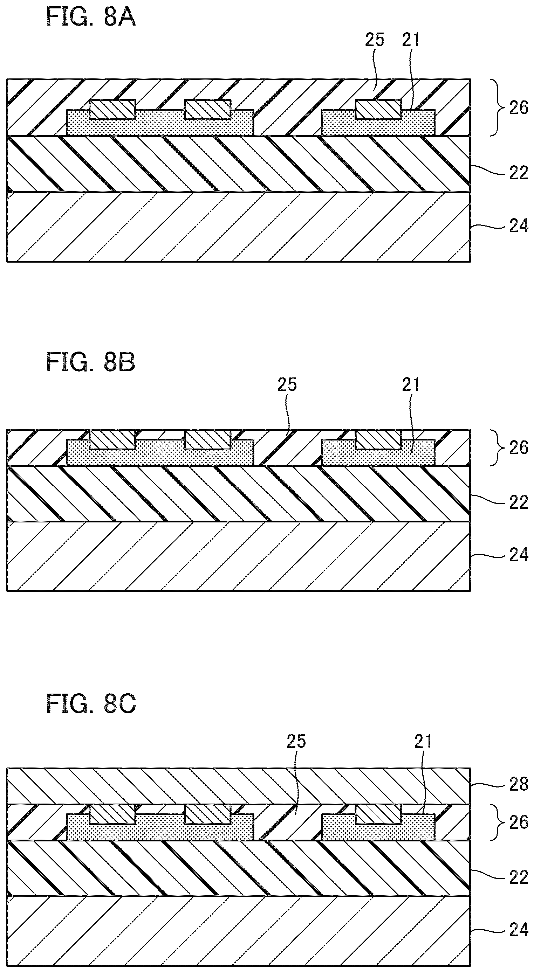

Hereinafter, a specific example of the fourth embodiment will be described with reference to Figs. 8A to 8F.

Examples of the processing performed on the electronic device layer in Step 5B include a grinding step and a wiring layer forming step.

### <<Grinding step>>

The grinding step is a step of grinding the resin part of the layer of the sealing resin 25 in the electronic device layer 26 such that a part of the semiconductor chip substrate 21 is exposed.

For example, as shown in Fig. 8B, the sealing resin part is ground by grinding the layer of the sealing resin 25 of the laminate shown in Fig. 8A until the layer has a thickness substantially equal to that of the semiconductor chip substrate 21. The laminate shown in Fig. 8A is the same laminate as the laminate shown in Figs. 4 and 6C.

### <<Wiring layer forming step>>

The wiring layer forming step is a step of forming a wiring layer on the exposed semiconductor chip substrate 21 after the grinding step.

In Fig. 8C, a wiring layer 28 is formed on the electronic device layer 26 including a layer of the semiconductor chip substrate 21 and the sealing resin 25.

The wiring layer 28 is also called a redistribution layer (RDL), is a thin-film wiring body constituting wiring connected to a substrate, and may have a single-layer or multi-layer structure. The wiring layer may be, but is not limited to, one in which wiring is formed of a conductor (for example, metals such as aluminum, copper, titanium, nickel, gold, and silver, and alloys such as a silver-tin alloy) between dielectrics (for example, photosensitive resin such as silicon oxide (SiOₓ) and photosensitive epoxy) .

Examples of the method for forming the wiring layer 28 include the following methods.

First, a dielectric layer of silicon oxide (SiOₓ), photosensitive resin, or the like is formed on the layer of the sealing resin 25. The dielectric layer made of silicon oxide can be formed by, for example, a sputtering method or a vacuum vapor deposition method. The dielectric layer made of photosensitive resin can be formed by applying photosensitive resin onto the layer of the sealing resin 25 by a method, for example, spin coating, dipping, roller blade, spray coating, or slit coating.

Subsequently, wiring is formed on the dielectric layer with a conductor such as metal. As a method for forming the wiring, for example, known semiconductor process techniques such as lithography processing such as photolithography (registry lithography) or etching processing can be used. Examples of such lithography processing include lithography processing using a positive resist material and lithography processing using a negative resist material.

In the method for producing a laminate according to the fourth embodiment, a bump can be further formed on the wiring layer 28 or an element can be mounted thereon. The element can be mounted on the wiring layer 28 using, for example, a chip mounter or the like.

The laminate according to the fourth embodiment may be a laminate prepared in a process based on fan-out technology in which a terminal provided on a semiconductor chip substrate is mounted on a wiring layer extending outside the chip area.

In Step 6B, examples of the method for separating (releasing) the electronic device layer from the support substrate include, but are not limited to, mechanical releasing with equipment having a sharp portion, and releasing by peeling between the support and the electronic device layer.

When the laminate has a release agent layer, for example, by irradiating the release agent layer with light from the support substrate side, the release agent layer is altered (for example, the release agent layer is separated or decomposed) as described above, and thereafter, for example, one of the substrates is pulled up, and the electronic device layer and the support substrate can be easily separated from each other.

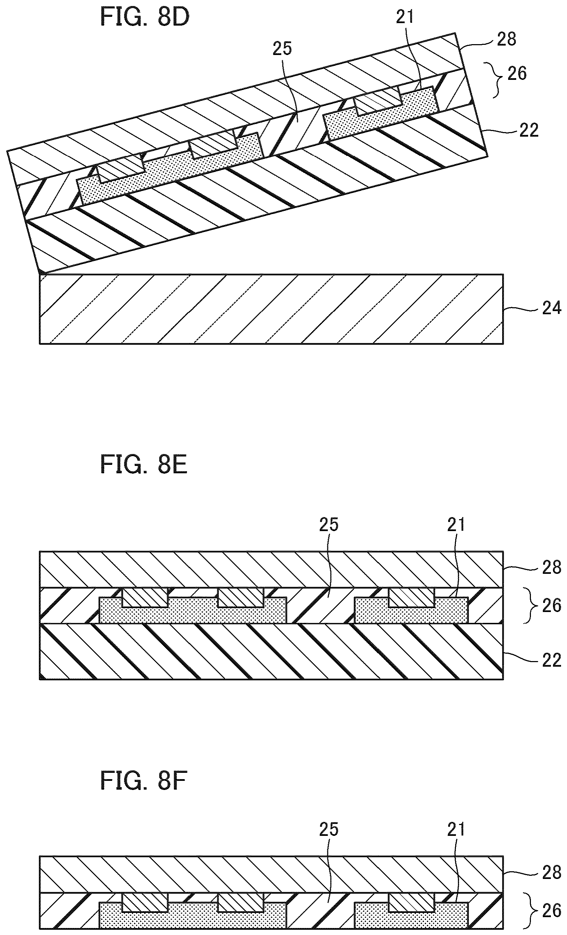

Figs. 8D and 8E are schematic cross-sectional views for describing a separation method for the laminate, and Fig. 8F is a schematic cross-sectional view for describing a cleaning method after separation of the laminate. One embodiment of the method for manufacturing a semiconductor package (electronic component) can be described with reference to Figs. 8D to 8F.

The step of separating the laminate is a step of separating the electronic device layer 26 and the support substrate 24 from each other using a releasing device (not shown) as shown in Figs. 8D and 8E.

The substrate can be cleaned by spraying the cleaning agent composition onto the surface of at least one of the separated electronic device layer and the separated support substrate, or immersing the separated electronic device layer or the separated support substrate in the cleaning agent composition.

In addition, the surface of the processed electronic device layer or the like may be cleaned using a removal tape or the like.

For example, in Fig. 8E, the adhesive layer 22 adheres to the electronic device layer 26 after the separation step, but the adhesive layer 22 can be removed by decomposing the adhesive layer 22 using a cleaning agent composition such as an acid or an alkali. By removing the adhesive layer, a processed electronic device layer (electronic component) as shown in Fig. 8F can be suitably obtained.

The constituent elements and method elements relating to the above-described steps of the method for manufacturing a processed electronic device layer of the present invention may be variously changed without departing from the gist of the present invention.

The method for manufacturing a processed electronic device layer of the present invention may include steps other than the above-described steps.

### Examples

Hereinafter, the present invention will be more specifically described with reference to examples, but the present invention is not limited to the following examples. The apparatus used is as follows.

### [Apparatus]

(1) Stirrer A: ARE-500, planetary centrifugal mixer manufactured by Thinky Corporation
(2) Viscometer: TVE-22H, rotational viscometer manufactured by Toki Sangyo Co.,Ltd.
(3) Optical film thickness meter (film thickness measurement): F-50 manufactured by Filmetrics, Inc.
(4) Vacuum bonding apparatus: XBS-300 manufactured by SÜSS MicroTec SE
(5) Measurement of weight average molecular weight and dispersity: GPC apparatus (EcoSEC, HLC-8320GPC manufactured by Tosoh Corporation) and GPC column (TSKgel SuperMultipore HZ-N and TSKgel SuperMultipore HZ-H manufactured by Tosoh Corporation)
   · Column temperature: 40°C
   · Eluent (elution solvent): tetrahydrofuran
   · Flow rate: 0.35 mL/min
   · Standard sample: polystyrene (manufactured by Sigma-Aldrich Co. LLC.)
(6) Vacuum heating device: VJ-300-S manufactured by Ayumi Industry Co., Ltd.
(7) Dynamic viscoelasticity (DMA) device: Q-800 manufactured by TA Instruments Japan Inc.
(8) Laser irradiation apparatus: Lambda SX manufactured by Coherent, Inc.

Hereinafter, the structures and characteristics of some polysiloxanes used are shown. 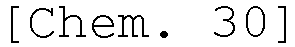 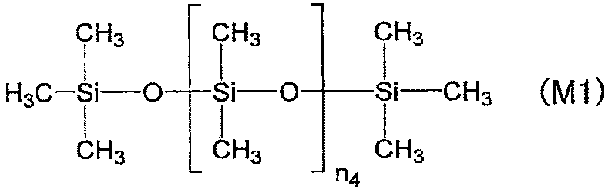
(In Formula (M1), n₄ represents the number of repeating units, and is a positive integer.) 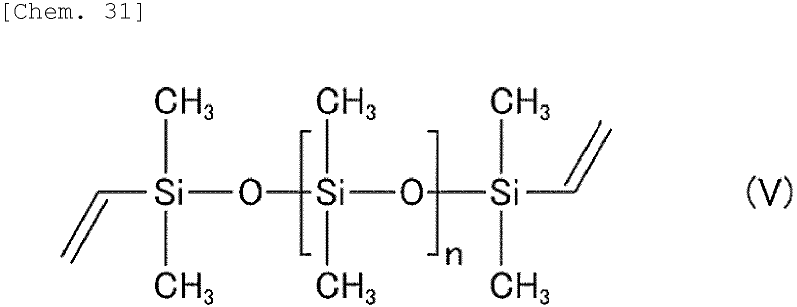
(In Formula (V), n represents the number of repeating units, and is a positive integer.) 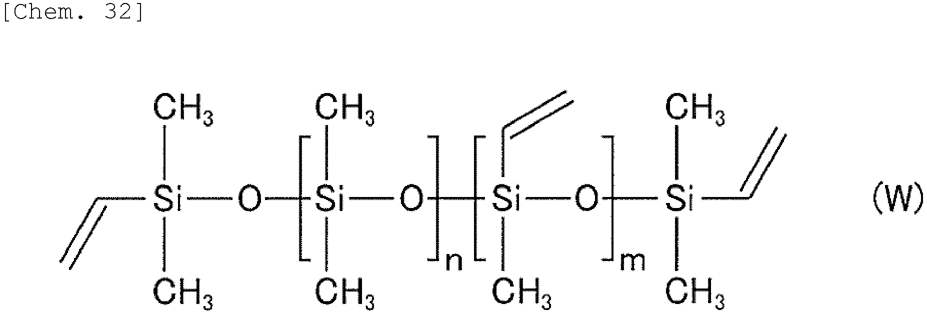
(In Formula (W), n and m represent the number of repeating units, and each independently represent a positive integer.)

**[Table 1]**

| Vinyl group-containing linear polydimethylsiloxane | Number average molecular weight Mn | Weight average molecular weight Mw | Mw/Mn |
|---|---|---|---|
| v2 | 8515 | 16187 | 1.92 |
| v3 | 14596 | 35662 | 2.45 |
| v1 | 83236 | 153801 | 1.85 |

### [1] Preparation of adhesive composition

### [Preparation Example 1-1]

To a 200 mL stirring vessel dedicated to a planetary centrifugal mixer, 74.86 g of a vinyl group-containing linear polydimethylsiloxane v2 having a viscosity of 200 mPa·s and represented by the above Formula (V) (v2 in Table 1, manufactured by Wacker Chemie AG) as the component (a1), 35.70 g of a vinyl group-containing linear polydimethylsiloxane v1 having a viscosity of 100,000 mPa·s and represented by the above Formula (V) (v1 in Table 1, manufactured by Wacker Chemie AG) as the component (a1), 7.39 g of an SiH group-containing linear polydimethylsiloxane having a viscosity of 100 mPa·s (manufactured by Wacker Chemie AG) as the component (a2),0.31 g of 1,1-diphenyl-2-propyne-1-ol (manufactured by Tokyo Chemical Industry Co., Ltd.) as the component (A-4), 0.31 g of 1-ethynyl-1-cyclohexanol (manufactured by Wacker Chemie AG) as the component (A-4), and 6.16 g of a polyorganosiloxane represented by the above Formula (M1) (complex viscosity: 6,000 Pa·s, weight average molecular weight: 642,000 (dispersity: 2.6), trade name: GENIOPLAST GUM manufactured by Wacker Chemie AG) as the component (B) were added and stirred with a stirrer A for 10 minutes to obtain a mixture (I).

To a 50 mL screw tube, 0.15 g of a platinum catalyst (manufactured by Wacker Chemie AG) as the component (A-3) and 6.19 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were added and stirred with the planetary centrifugal mixer for 5 minutes to obtain a mixture (II).

To the mixture (I), 5.28 g of the obtained mixture (II) was added, and the mixture was stirred with the stirrer A for 5 minutes to obtain a mixture (III).

The finally obtained mixture (III) was filtered through a 300-mesh nylon filter to obtain an adhesive composition. The viscosity of the adhesive composition measured using the rotational viscometer was 6,600 mPa·s.

### [Preparation Example 1-2]

To a 100 mL stirring vessel dedicated to a planetary centrifugal mixer, 9.98 g of a p-menthane solution of a vinyl group-containing MQ resin (manufactured by Wacker Chemie AG) (concentration: 80.7 mass%) as the component (a1) and 0.20 g of 1,1-diphenyl-2-propyne-1-ol (manufactured by Tokyo Chemical Industry Co., Ltd.) as the component (A-4) were added and stirred with the stirrer A for 5 minutes to obtain a mixture (I).

To the obtained mixture (I), 48.64 g of a vinyl group-containing linear polydimethylsiloxane v2 having a viscosity of 200 mPa·s and represented by the above Formula (V) (v2 in Table 1, manufactured by Wacker Chemie AG) as the component (a1), 14.45 g of a vinyl group-containing linear polydimethylsiloxane v1 having a viscosity of 100,000 mPa·s and represented by the above Formula (V) (v1 in Table 1, manufactured by Wacker Chemie AG) as the component (a1), and 5.62 g of an SiH group-containing linear polydimethylsiloxane having a viscosity of 100 mPa·s (manufactured by Wacker Chemie AG) as the component (a2) were added, and 0.21 g of 1-ethynyl-1-cyclohexanol (manufactured by Wacker Chemie AG) as the component (A-4), and 4.08 g of a polyorganosiloxane represented by the above Formula (M1) (complex viscosity: 6,000 Pa·s, weight average molecular weight: 642,000 (dispersity: 2.6), trade name: GENIOPLAST GUM manufactured by Wacker Chemie AG) as the component (B) were further added thereto and stirred with the stirrer A for 10 minutes to obtain a mixture (II).

To a 50 mL screw tube, 0.12 g of a platinum catalyst (manufactured by Wacker Chemie AG) as the component (A-3) and 5.06 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were added and stirred with the stirrer A for 5 minutes to obtain a mixture (III).

To the mixture (II), 3.47 g of the obtained mixture (III) was added, and the mixture was stirred with the stirrer A for 5 minutes to obtain a mixture (IV).

Finally, the obtained mixture (IV) was filtered through a 300-mesh nylon filter to obtain an adhesive composition. The viscosity of the adhesive composition measured using the rotational viscometer was 3,600 mPa·s.

### [Preparation Example 1-3]

To a 100 mL stirring vessel dedicated to a planetary centrifugal mixer, 9.92 g of a p-menthane solution of a vinyl group-containing MQ resin (manufactured by Wacker Chemie AG) (concentration: 80.7 mass%) as the component (a1) and 0.21 g of 1,1-diphenyl-2-propyne-1-ol (manufactured by Tokyo Chemical Industry Co., Ltd.) as the component (A-4) were added and stirred with the stirrer A for 5 minutes to obtain a mixture (I).

To the obtained mixture (I), 61.79 g of a vinyl group-containing linear polydimethylsiloxane v2 having a viscosity of 200 mPa·s and represented by the above Formula (V) (v2 in Table 1, manufactured by Wacker Chemie AG) as the component (a1) and 6.81 g of an SiH group-containing linear polydimethylsiloxane having a viscosity of 100 mPa·s (manufactured by Wacker Chemie AG) as the component (a2) were added, and 0.21 g of 1-ethynyl-1-cyclohexanol (manufactured by Wacker Chemie AG) as the component (A-4), and 4.35 g of a polyorganosiloxane represented by the above Formula (M1) (complex viscosity: 6,000 Pa·s, weight average molecular weight: 642,000 (dispersity: 2.6), trade name: GENIOPLAST GUM manufactured by Wacker Chemie AG) as the component (B) were further added thereto and stirred with the stirrer A for 10 minutes to obtain a mixture (II).

To a 50 mL screw tube, 0.13 g of a platinum catalyst (manufactured by Wacker Chemie AG) as the component (A-3) and 5.42 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were added and stirred with the stirrer A for 5 minutes to obtain a mixture (III).

To the mixture (II), 3.69 g of the obtained mixture (III) was added, and the mixture was stirred with the stirrer A for 5 minutes to obtain a mixture (IV).

Finally, the obtained mixture (IV) was filtered through a 300-mesh nylon filter to obtain an adhesive composition. The viscosity of the adhesive composition measured using the rotational viscometer was 1,100 mPa·s.

### [Preparation Example 1-4]

In a 200 mL stirring vessel dedicated to a planetary centrifugal mixer, 9.72 g of a base polymer (consisting of a vinyl group-containing MQ resin (manufactured by Wacker Chemie AG) as the component (a1) and a vinyl group-containing linear polydimethylsiloxane v2 having a viscosity of 200 mPa·s and represented by the above Formula (V) (v2 in Table 1) as the component (a1) and an SiH group-containing linear polydimethylsiloxane having a viscosity of 100 mPa·s as the component (a2)) (manufactured by Wacker Chemie AG) and 0.25 g of 1-ethynyl-1-cyclohexanol (manufactured by Wacker Chemie AG) as the component (A-4) were charged, and 0.21 g of 1,1-diphenyl-2-propyne-1-ol (manufactured by Tokyo Chemical Industry Co., Ltd.) as the component (A-4), 10.00 g of polyorganosiloxane represented by the above Formula (M1) (complex viscosity: 6,000 Pa·s, weight average molecular weight: 642,000 (dispersity: 2.6), trade name: GENIOPLAST GUM manufactured by Wacker Chemie AG) as the component (B), and 34.94 g of p-menthane (manufactured by Nippon Terpene Chemicals, Inc.) as a solvent were further added thereto and stirred with the stirrer A for 10 minutes to obtain a mixture (I).

To the obtained mixture (I), 69.96 g of a vinyl group-containing linear polydimethylsiloxane v2 having a viscosity of 200 mPa·s and represented by the above Formula (V) (v2 in Table 1, manufactured by Wacker Chemie AG) as the component (a1) and 10.30 g of an SiH group-containing linear polydimethylsiloxane having a viscosity of 100 mPa·s (manufactured by Wacker Chemie AG) as the component (a2) were added and stirred with the stirrer A for 5 minutes to obtain a mixture (II).

To a 50 mL screw tube, 0.15 g of a platinum catalyst (manufactured by Wacker Chemie AG) as the component (A-3) and 15.01 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were added and stirred with the stirrer A for 5 minutes to obtain a mixture (III).

To the mixture (II), 10.11 g of the obtained mixture (III) was added, and the mixture was stirred with the stirrer A for 5 minutes to obtain a mixture (IV).

Finally, the obtained mixture (IV) was filtered through a 300-mesh nylon filter to obtain an adhesive composition. The viscosity of the adhesive composition measured using the rotational viscometer was 2,400 mPa·s.

### [Comparative Preparation Example 1-1]

In a 600 mL stirring vessel dedicated to a planetary centrifugal mixer, 150 g of a base polymer (consisting of a vinyl group-containing linear polydimethylsiloxane v2 having a viscosity of 200 mPa·s and represented by the above Formula (V) (v2 in Table 1) and a vinyl group-containing MQ resin as the component (a1)) (manufactured by Wacker Chemie AG), 15.81 g of an SiH group-containing linear polydimethylsiloxane having a viscosity of 100 mPa·s (manufactured by Wacker Chemie AG) as the component (a2), and 0.17 g of 1-ethynyl-1-cyclohexanol (manufactured by Wacker Chemie AG) as the component (A-4) were charged and stirred with the stirrer A for 5 minutes to obtain a mixture (I).

In a 50 mL screw tube, 0.33 g of a platinum catalyst (manufactured by Wacker Chemie AG) as the component (A-3) and 9.98 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were stirred with the planetary centrifugal mixer for 5 minutes to obtain a mixture (II).

To the mixture (I), 0.52 g of the obtained mixture (II) was added, and the mixture was stirred with the stirrer A for 5 minutes to obtain a mixture (III).

The finally obtained mixture (III) was filtered through a 300-mesh nylon filter to obtain an adhesive composition. The viscosity of the adhesive composition measured using the rotational viscometer was 9,900 mPa·s.

### [Comparative Preparation Example 1-2]

To a 600 mL stirring vessel dedicated to a planetary centrifugal mixer, 104.14 g of a p-menthane solution (concentration: 80.7 mass%) of an MQ resin (manufactured by Wacker Chemie AG) having a polysiloxane skeleton and a vinyl group as the component (a1), 58.11 g of polyorganosiloxane represented by the above Formula (M1) (manufactured by Wacker Chemie AG, trade name: AK1000000, viscosity: 1,000,000 mm²/s) as the component (B), 34.94 g of p-menthane (manufactured by Nippon Terpene Chemicals, Inc.) as a solvent, and 6.20 g of n-decane (manufactured by Sankyo Chemical Co., Ltd.) as a solvent were added and stirred with the stirrer A for 5 minutes to obtain a mixture (I).

To the obtained mixture (I), 16.79 g of an SiH group-containing linear polydimethylsiloxane having a viscosity of 100 mPa·s (manufactured by Wacker Chemie AG) as the component (a2) and 24.54 g of a vinyl group-containing linear polydimethylsiloxane v2 having a viscosity of 200 mPa·s and represented by the above Formula (V) (v2 in Table 1, manufactured by Wacker Chemie AG) as the component (a1) were added to obtain a mixture (II).

1.61 g of 1,1-diphenyl-2-propyne-1-ol (manufactured by Tokyo Chemical Industry Co., Ltd.) as the component (A-4), 1.61 g of 1-ethynyl-1-cyclohexanol (manufactured by Wacker Chemie AG) as the component (A-4), and 3.23 g of p-menthane (manufactured by Nippon Terpene Chemicals, Inc.) as a solvent were stirred with the stirrer for 60 minutes to obtain a mixture (III).

To the mixture (II), 1.29 g of the obtained mixture (III) was added, and the mixture was stirred with the stirrer for 5 minutes to obtain a mixture (IV).

0.65 g of a platinum catalyst (manufactured by Wacker Chemie AG) as the component (A-3) and 19.37 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were stirred with the stirrer A for 5 minutes to obtain a mixture (V).

To the mixture (IV), 4.00 g of the obtained mixture (V) was added, and the mixture was stirred with the stirrer A for 5 minutes to obtain a mixture (VI).

Finally, the obtained mixture (VI) was filtered through a 300-mesh nylon filter to obtain an adhesive composition. The viscosity of the obtained adhesive composition was 3,000 mPa·s.

### [Comparative Preparation Example 1-3]

To a 200 mL stirring vessel dedicated to a planetary centrifugal mixer, 73.44 g of a p-menthane solution (concentration: 81.7 mass%) of an MQ resin (manufactured by Wacker Chemie AG) having a polysiloxane skeleton and a vinyl group as the component (a1), 27.91 g of a p-menthane solution (concentration: 60.3 mass%) of polyorganosiloxane represented by the above Formula (M1) (complex viscosity: 6,000 Pa·s, weight average molecular weight: 642,000 (dispersity: 2.6)) as the component (B), 0.23 g of 1,1-diphenyl-2-propyne-1-ol (manufactured by Tokyo Chemical Industry Co., Ltd.) as the component (A-4), 0.24 g of 1-ethynyl-1-cyclohexanol (manufactured by Wacker Chemie AG) as the component (A-4), 3.87 g of p-menthane (manufactured by Nippon Terpene Chemicals, Inc.) as a solvent, and 3.27 g of n-decane (manufactured by Sankyo Chemical Co., Ltd.) as a solvent were stirred with the stirrer A for 5 minutes to obtain a mixture (I).

To the obtained mixture (I), 17.54 g of a vinyl group-containing linear polydimethylsiloxane v2 having a viscosity of 200 mPa·s and represented by the above Formula (V) (v2 in Table 1, manufactured by Wacker Chemie AG) as the component (a1) and 12.01 g of an SiH group-containing linear polydimethylsiloxane having a viscosity of 100 mPa·s (manufactured by Wacker Chemie AG) as the component (a2) were added and stirred with the stirrer A for 5 minutes to obtain a mixture (II).

0.04 g of a platinum catalyst (manufactured by Wacker Chemie AG) as the component (A-3) and 4.15 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were stirred with the stirrer A for 5 minutes to obtain a mixture (III).

To the mixture (II), 2.79 g of the obtained mixture (III) was added, and the mixture was stirred with the stirrer A for 5 minutes to obtain a mixture (IV).

Finally, the obtained mixture (IV) was filtered through a 300-mesh nylon filter to obtain an adhesive composition. The viscosity of the obtained adhesive composition was 4,000 mPa·s.

### [Comparative Preparation Example 1-4]

To a 200 mL stirring vessel dedicated to a planetary centrifugal mixer, 12.41 g of a p-menthane solution of a vinyl group-containing MQ resin (manufactured by Wacker Chemie AG) (concentration: 80.7 mass%) as the component (a1) and 0.25 g of 1,1-diphenyl-2-propyne-1-ol (manufactured by Tokyo Chemical Industry Co., Ltd.) as the component (A-4) were added and stirred with the stirrer A for 5 minutes to obtain a mixture (I).

To the obtained mixture (I), 60.51 g of a vinyl group-containing linear polydimethylsiloxane v2 having a viscosity of 200 mPa·s and represented by the above Formula (V) (v2 in Table 1, manufactured by Wacker Chemie AG) as the component (a1), 14.52 g of an SiH group-containing linear polydimethylsiloxane having a viscosity of 100 mPa·s (manufactured by Wacker Chemie AG) as the component (a2), and 12.00 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were added, and 0.25 g of 1-ethynyl-1-cyclohexanol (manufactured by Wacker Chemie AG) as the component (A-4) and 5.12 g of polyorganosiloxane represented by the above Formula (M1) (complex viscosity: 6,000 Pa·s, weight average molecular weight: 642,000 (dispersity: 2.6), trade name: GENIOPLAST GUM manufactured by Wacker Chemie AG) as the component (B) were further added thereto and stirred with the stirrer A for 10 minutes to obtain a mixture (II).

To a 50 mL screw tube, 0.0.25 g of a platinum catalyst (manufactured by Wacker Chemie AG) as the component (A-3) and 7.50 g of a vinyl group-containing linear polydimethylsiloxane v3 having a viscosity of 1,000 mPa·s and represented by the above Formula (W) (v3 in Table 1, manufactured by Wacker Chemie AG) as the component (a1) were added and stirred with the stirrer A for 5 minutes to obtain a mixture (III).

To the mixture (II), 3.10 g of the obtained mixture (III) was added, and the mixture was stirred with the stirrer A for 5 minutes to obtain a mixture (IV).

Finally, the obtained mixture (IV) was filtered through a 300-mesh nylon filter to obtain an adhesive composition. The viscosity of the adhesive composition measured using the rotational viscometer was 1,000 mPa·s.

### [2] Preparation of Release Agent Composition

### [Preparation Example 2]

In a flask, 56.02 g of N-phenyl-1-naphthylamine, 50.00 g of 1-pyrenecarboxaldehyde, 6.67 g of 4-(trifluoromethyl)benzaldehyde, and 2.46 g of methanesulfonic acid were charged, 86.36 g of 1,4-dioxane and 86.36 g of toluene were added thereto, and the mixture was refluxed and stirred for 18 hours under a nitrogen atmosphere.

The reaction mixture was allowed to cool, then diluted by adding 96 g of tetrahydrofuran, and the obtained diluted solution was added dropwise to methanol to obtain a precipitate. The obtained precipitate was recovered by filtration, and the filtrate was cleaned with methanol, and dried at 60°C under reduced pressure to obtain 72.12 g of a novolac resin.

The weight average molecular weight of the novolac resin as a polymer measured in terms of polystyrene by GPC was 1,100.

In 95.58 g of propylene glycol monomethyl ether acetate, 3.6 g of the obtained novolac resin, 0.72 g of TMOM-BP (the following structural formula) as a crosslinking agent, and 0.1 g of pyridinium paratoluenesulfonate were dissolved, and the obtained solution was filtered using a polyethylene microfilter having a pore diameter of 0.2 µm to obtain a release agent composition.

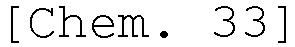

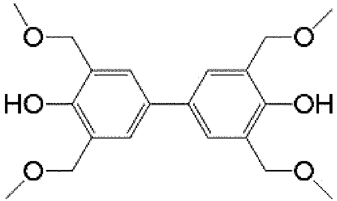

### [3] Evaluation of mechanical properties (DMA measurement)

### [3-1] Production of film for evaluation

### [Example 1-1]

A 100 mm silicon wafer (thickness: 700 µm) was evenly covered with aluminum foil, and the adhesive composition obtained in Preparation Example 1-1 was applied thereon by spin coating, and heated on a hot plate set at 110°C for 1.5 minutes followed by heating on a hot plate set at 200°C for 9 minutes, thereby forming an adhesive layer having a thickness of about 100 µm. Thereafter, the aluminum foil with the adhesive layer was removed from the silicon wafer.

Thereafter, the aluminum foil with the adhesive layer is immersed in 6 N hydrochloric acid to dissolve the aluminum foil, and the remaining film of the adhesive layer was recovered. The recovered film was cut into a width of 5 mm and a length of 10 cm.

### [Example 1-2]

A film was prepared in the same manner as in Example 1-1, except that the adhesive composition obtained in Preparation Example 1-2 was used in place of the adhesive composition obtained in Preparation Example 1-1.

### [Example 1-3]

A film was prepared in the same manner as in Example 1-1, except that the adhesive composition obtained in Preparation Example 1-3 was used in place of the adhesive composition obtained in Preparation Example 1-1.

### [Example 1-4]

A film was prepared in the same manner as in Example 1-1, except that the adhesive composition obtained in Preparation Example 1-4 was used in place of the adhesive composition obtained in Preparation Example 1-1.

### [Comparative Example 1-1]

A film was prepared in the same manner as in Example 1-1, except that the adhesive composition obtained in Comparative Preparation Example 1-1 was used in place of the adhesive composition obtained in Preparation Example 1-1.

### [Comparative Example 1-2]

A film was prepared in the same manner as in Example 1-1, except that the adhesive composition obtained in Comparative Preparation Example 1-2 was used in place of the adhesive composition obtained in Preparation Example 1-1.

### [Comparative Example 1-3]

A film was prepared in the same manner as in Example 1-1, except that the adhesive composition obtained in Comparative Preparation Example 1-3 was used in place of the adhesive composition obtained in Preparation Example 1-1.

### [Comparative Example 1-4]

A film was prepared in the same manner as in Example 1-1, except that the adhesive composition obtained in Comparative Preparation Example 1-4 was used in place of the adhesive composition obtained in Preparation Example 1-1.

### [3-2] Measurement of mechanical properties

The mechanical properties of the adhesive layer films obtained in Examples 1-1 to 1-4 and Comparative Examples 1-1 to 1-4 were calculated using the DMA device from detected strain obtained by fixing the films to a jig and applying a load. When the strain was generated in the film, the temperature was fixed at 30°C, and the tensile speed was 3.0 N/min.

**[Table 2]**

| Example | Adhesive layer | Elongation [%] | Stress [MPa] | Elastic modulus [MPa] | Tensile strength [MPa] |
|---|---|---|---|---|---|
| Example 1-1 | Preparation Example 1-1 | 102.0 | 0.10 | 0.3 | 0.4 |
| Example 1-2 | Preparation Example 1-2 | 111.7 | 0.14 | 0.7 | 1.0 |
| Example 1-3 | Preparation Example 1-3 | 131.2 | 0.24 | 1.3 | 2.1 |
| Example 1-4 | Preparation Example 1-4 | 112.2 | 0.26 | 1.3 | 1.9 |
| Comparative Example 1-1 | Comparative Preparation Example 1-1 | 49.0 | 0.50 | 3.1 | 1.1 |
| Comparative Example 1-2 | Comparative Preparation Example 1-2 | 23.9 | 0.51 | 5.2 | 0.5 |
| Comparative Example 1-3 | Comparative Preparation Example 1-3 | 46.8 | 1.10 | 18.6 | 1.7 |
| Comparative Example 1-4 | Comparative Preparation Example 1-4 | 64.8 | 0.58 | 3.2 | 1.9 |

### [4] Adhesiveness test

### [4-1] Preparation of laminate

### [Example 2-1]

The adhesive composition obtained in Preparation Example 1-1 was applied to a 300 mm silicon wafer (thickness: 770 µm) as a device-side wafer (semiconductor substrate) by spin coating, and heated (preheated) at 110°C for 1.5 minutes to form an adhesive coating layer on a circuit surface of the silicon wafer so that the adhesive layer had a final thickness of about 65 µm in the laminate.

On the other hand, the release agent composition obtained in Preparation Example 2 was applied to a 300 mm glass wafer (thickness: 700 µm) as a carrier-side wafer (support) by spin coating, and heated at 250°C for 5 minutes to form a release layer on the glass wafer so that the release layer has a final thickness of about 200 nm in the laminate.

Thereafter, in the vacuum bonding apparatus, the semiconductor substrate and the support substrate were bonded so as to sandwich the adhesive coating layer and the release layer, and heated (postheated) on a hot plate at 200°C for 9 minutes with the semiconductor substrate side facing down to prepare a laminate. Bonding was performed at a temperature of 23°C and a reduced pressure of 1,000 Pa, under a load of 30 N.

### [Example 2-2]

A laminate was prepared in the same manner as in Example 2-1, except that the adhesive composition obtained in Preparation Example 1-2 was used in place of the adhesive composition obtained in Preparation Example 1-1.

### [Example 2-3]

A laminate was prepared in the same manner as in Example 2-1, except that the adhesive composition obtained in Preparation Example 1-3 was used in place of the adhesive composition obtained in Preparation Example 1-1.

### [Example 2-4]

A laminate was prepared in the same manner as in Example 2-1, except that the adhesive composition obtained in Preparation Example 1-4 was used in place of the adhesive composition obtained in Preparation Example 1-1.

### [Comparative Example 2-1]

A laminate was prepared in the same manner as in Example 2-1, except that the adhesive composition obtained in Comparative Preparation Example 1-1 was used in place of the adhesive composition obtained in Preparation Example 1-1.

### [Comparative Example 2-2]

A laminate was prepared in the same manner as in Example 2-1, except that the adhesive composition obtained in Comparative Preparation Example 1-2 was used in place of the adhesive composition obtained in Preparation Example 1-1.

### [Comparative Example 2-3]

A laminate was prepared in the same manner as in Example 2-1, except that the adhesive composition obtained in Comparative Preparation Example 1-3 was used in place of the adhesive composition obtained in Preparation Example 1-1.

### [Comparative Example 2-4]

A laminate was prepared in the same manner as in Example 2-1, except that the adhesive composition obtained in Comparative Preparation Example 1-4 was used in place of the adhesive composition obtained in Preparation Example 1-1.

### [4-2] Evaluation of adhesiveness

The adhesiveness was evaluated by visually confirming the presence or absence of voids from the glass wafer (support) side of the laminate.

A case where no void was confirmed was evaluated as "good," and a case where voids were confirmed was evaluated as "poor."

As a result, each of the laminates obtained in Examples 2-1 to 2-4 and Comparative Examples 2-1 to 2-4 in which no void was confirmed was rated as "good."

### [5] Heat resistance test (Examples 3-1 to 3-4 and Comparative Examples 3-1 to 3-4)

The heat resistance test was performed by subjecting each of the laminates obtained in Examples 2-1 to 2-4 and Comparative Examples 2-1 to 2-4 to a heat treatment using a vacuum heating device. The treatment was performed by the following procedure.

Each laminate described above was placed on a pin of a stage in a vacuum heating device set at 350°C, and the inside of the device was filled with nitrogen after bringing the device into a vacuum state with a door closed. Thereafter, the pin was lowered, and each laminate was heated on the stage. Heating was performed for 8 hours.

The condition of the silicon wafer of each laminate after the treatment was visually observed through the glass wafer as a support substrate to confirm the presence or absence of voids.

A case where no void was observed after treatment for 8 hours was evaluated as "∘," and a case where a void was observed was evaluated as "×." The results are shown in Table 3.

**[Table 3]**

| Example | Adhesive layer | Heat resistance |
|---|---|---|
| Example 3-1 | Preparation | ○ |
| | Example 1-1 | |
| Example 3-2 | Preparation Example 1-2 | ○ |
| Example 3-3 | Preparation Example 1-3 | ○ |
| Example 3-4 | Preparation Example 1-4 | ○ |
| Comparative Example 3-1 | Comparative Preparation Example 1-1 | × |
| Comparative Example 3-2 | Comparative Preparation Example 1-2 | × |
| Comparative Example 3-3 | Comparative Preparation Example 1-3 | × |
| Comparative Example 3-4 | Comparative Preparation Example 1-4 | × |

### [6] Evaluation of laser releasability

Using the laser irradiation apparatus, each release layer was irradiated with a laser having a wavelength of 308 nm at 200 mJ/cm² from the glass wafer side of each fixed laminate. Then, each support substrate was manually lifted to confirm whether or not the support substrate can be released. As a result, in each of the laminates obtained in Examples 2-1 to 2-4, the support substrate was successfully released without a load by lifting.

### Reference Signs List

- 1: Semiconductor substrate
- 2: Adhesive layer
- 2a: Adhesive coating layer
- 3: Release agent layer
- 4: Support substrate
- 21: Semiconductor chip substrate
- 22: Adhesive layer
- 22': Adhesive coating layer
- 23: Release agent layer
- 24: Support substrate
- 25: Sealing resin
- 26: Electronic device layer
- 28: Wiring layer

## Claims

1. An adhesive composition cured by a hydrosilylation reaction, wherein
an adhesive layer formed from the adhesive composition has an elongation of 70% or more.

2. The adhesive composition according to claim 1, wherein the adhesive layer has a stress of 0.40 MPa or less at 20% elongation.

3. The adhesive composition according to claim 1, wherein the adhesive layer has an elongation of 150% or less.

4. The adhesive composition according to claim 2, wherein the adhesive layer has a stress of 0.05 MPa or more at 20% elongation.

5. The adhesive composition according to claim 1, comprising: a component (A-1) having an alkenyl group having 2 to 40 carbon atoms and being bonded to a silicon atom; and a component (A-2) having an Si-H group.

6. The adhesive composition according to claim 5, wherein the component (A-1) contains a polyorganosiloxane (a1) having an alkenyl group having 2 to 40 carbon atoms and being bonded to a silicon atom.

7. The adhesive composition according to claim 5, wherein the component (A-2) contains a polyorganosiloxane having an Si-H group.

8. The adhesive composition according to claim 1, comprising: a polyorganosiloxane as a component that does not cause a hydrosilylation reaction.

9. The adhesive composition according to claim 1, used to form an adhesive layer of a laminate including
a semiconductor substrate or an electronic device layer,
a support substrate, and
the adhesive layer provided between the semiconductor substrate or the electronic device layer and the support substrate.

10. A laminate comprising:
a semiconductor substrate or an electronic device layer;
a support substrate; and
an adhesive layer provided between the semiconductor substrate or the electronic device layer and the support substrate, wherein
the adhesive layer is an adhesive layer formed from the adhesive composition according to any one of claims 1 to 9.

11. The laminate according to claim 10, further comprising: a release agent layer provided between the semiconductor substrate or the electronic device layer and the support substrate.

12. A method for manufacturing a processed semiconductor substrate or electronic device layer, the method comprising:
Step 5A of processing the semiconductor substrate of the laminate according to claim 10, or Step 5B of processing the electronic device layer of the laminate according to claim 10; and
Step 6A of separating the semiconductor substrate processed in Step 5A and the support substrate from each other, or Step 6B of separating the electronic device layer processed in Step 5B and the support substrate from each other.
